# EUROPEAN PATENT APPLICATION

(11) **EP 4 421 984 A1**
(43) Date of publication of application: **28.08.2024**
(21) Application number: 21961490.6
(22) Date of filing: 21.10.2021
(51) Int. Cl.: H01Q 1/32, H01Q 1/38, H01Q 1/46, H04B 7/0413

(54) **WIDEBAND ANTENNA ARRANGED ON VEHICLE**

(71) Applicant: LG Electronics Inc., Yeongdeungpo-gu Seoul 07336 (KR)
(72) Inventor: KIM, Changil, Seoul 06772 (KR); YUN, Changwon, Seoul 06772 (KR); YOUN, Yeomin, Seoul 06772 (KR); KIM, Yongkon, Seoul 06772 (KR); JEON, Cheolsoo, Seoul 06772 (KR)
(74) Representative: Vossius & Partner Patentanwälte Rechtsanwälte mbB
(86) International application number: PCT/KR2021/014782
(87) International publication number: WO 2023/068401

(57) **Abstract**

The antenna module mounted on a vehicle comprises: a PCB on which electronic components are arranged; a radiator which is electrically connected to the PCB through a side surface region, and which is formed of a metal pattern having a predetermined length and width and transmits and receives a first signal; a lower cover which is arranged under the PCB and which includes a metal plate having slot regions; and an upper cover which is engaged with the lower cover and accommodates the PCB and the radiator therein. The metal plate can comprise: a first slot region formed at one side of the metal plate so as to have a predetermined length and width; and a second slot region formed in parallel to the first slot region so as to have a predetermined length and width.

## Description

### Technical Field

This specification relates to a wideband antenna disposed in a vehicle. One particular implementation relates to an antenna module having a wideband antenna that is capable of operating in various communication systems, and to a vehicle having the same.

### Background Art

A vehicle may perform wireless communication services with other vehicles or nearby objects, infrastructures, or a base station. In this regard, various communication services may be provided using Long Term Evolution (LTE) communication, 5G communication, or WiFi communication technology.

In order to provide these various wireless communication services in a vehicle, an antenna may be disposed on a glass of the vehicle, above or below a roof of the vehicle. When the antenna is disposed on the glass of the vehicle, it may be implemented with a transparent antenna material. Meanwhile, when the antenna is disposed above or below the roof of the vehicle, an effect on a vehicle body and the roof of the vehicle may cause a change in antenna performance.

In this regard, there is a problem in that the vehicle body and the vehicle roof are formed of a metallic material to block radio waves. Accordingly, a separate antenna structure may be disposed above the vehicle body or the roof. Or, when the antenna structure is disposed below the vehicle body or roof, a portion of the vehicle body or roof corresponding to a region where the antenna structure is disposed may be formed of a non-metallic material.

Meanwhile, in order to provide WiFi communication services in a vehicle, a WiFi communication antenna needs to be provided in the vehicle. In relation to these WiFi communication services, the vehicle WiFi antenna needs to be configured to operate in a 5 GHz band in addition to a 2.4 GHz band. In this regard, existing antenna elements are implemented as resonance antenna elements with a limited bandwidth, so there is a problem in that bandwidth characteristics are limited.

Additionally, there is a need to provide wireless communication services in regions (areas) outside and inside a vehicle through vehicle antennas. In relation to this, when a vehicle antenna is disposed within the roof of the vehicle, there is a problem that it is difficult to provide a wireless signal to the region inside the vehicle.

### Disclosure of Invention

### Technical Problem

The present disclosure is directed to solving the aforementioned problems and other drawbacks. One aspect of the present disclosure is to provide an antenna structure operating to cover a full band of 4G/5G low band (LB).

Another aspect of the present disclosure is to provide an antenna structure operating even in a WiFi band in addition to a 4G/5G low band.

Still another aspect of the present disclosure is to provide a configuration capable of maintaining isolation between an antenna for multi-input/multi-output (MIMO) and a WiFi antenna while optimizing antenna performances therefor.

Still another aspect of the present disclosure is to apply a wireless signal to an inner region of a vehicle even in case where the exterior of a vehicle body or roof is made of a metal material.

Still another aspect of the present disclosure is to provide an antenna operating in a dual mode while using a ground region of a body, which constitutes an antenna module, as an antenna.

Another aspect of the present disclosure is to improve antenna performance of an antenna system while maintaining a height of the antenna system at a predetermined level or less.

Still another aspect of the present disclosure is to provide a structure for mounting an antenna system, which is capable of operating in a wide frequency band to support various communication systems, to a vehicle.

### Solution to Problem

In order to achieve the above or other aspects, there is provided an antenna module mounted on a vehicle according to an embodiment that includes: a printed circuit board (PCB) on which electronic components are disposed; a radiator electrically connected to the PCB, through a side region, and configured as a metal pattern having predetermined length and width to transmit and receive a first signal; a bottom cover disposed on a bottom of the PCB and configured as a metal plate with slot regions; and a top cover fastened to the bottom cover and configured to accommodate the PCB and the radiator therein. The metal plate may include: a first slot region formed on one side of the metal plate to have predetermined length and width; and a second slot region formed parallel to the first slot region to have predetermined length and width.

According to an embodiment, the metal plate may further include a branch member disposed between the first slot region and the second slot region and formed of a metal plate having predetermined length and width.

According to an embodiment, the antenna module may further include a first feeder disposed on a front surface of the PCB, and connected to the radiator to feed a first signal of a first band to the radiator. The first signal may be a lower band (LB) signal for 4G communication or 5G communication.

According to an embodiment, the radiator may include: a first metal pattern disposed parallel to the top cover and having an opening region; a second metal pattern connected vertically to the upper metal pattern and forming a side region; and a third metal pattern connected to the second metal pattern and the first feeder and configured to transmit the first signal of the first band to the second metal pattern.

According to an embodiment, the first feeder may be configured to feed a first signal of a second band higher than the first band to the slot regions. The PCB may be configured to be connected to the bottom cover through a ground contact portion. The first band may be a first sub-band of the low band (LB), and the second band may be a second sub-band higher than the first sub-band of the low band (LB).

According to an embodiment, the radiator may be configured to radiate the first signal of the first band and the slot regions of the metal plate configured to radiate the first signal of the second band constitute a main antenna that operates in the low band (LB) of 4G communication or 5G communication bands.

According to an embodiment, the antenna module may further include a second feeder disposed between the branch line and the metal plate forming the second slot region, and configured to feed a second signal of a third band higher than the second band to the second slot region. The third band may be a frequency band for WiFi communication.

According to an embodiment, the second slot region configured to radiate the second signal of the third band may constitute a WiFi antenna operating in a WiFi frequency band.

According to an embodiment, the radiator may operate as a first radiator that radiates the first signal of the first band fed from the first feeder. The slot regions may operate as a second radiator that radiates the first signal of the second band fed from the second feeder. The first radiator and the second radiator may constitute the main antenna.

According to an embodiment, the main antenna may be configured to radiate the first signal of the first band through the radiator. The main antenna may be configured to radiate the first signal of the second band through the slot regions including the first slot region and the second slot region, thus to operate in a first slot mode.

According to an embodiment, the WiFi antenna may be configured to radiate the second signal of the third band through the second slot region, thus to operate in a second slot mode.

According to an embodiment, the first slot region and the second slot region may be formed to have a first length and a second length in one axial direction. The metal plate may include: a first metal plate connected to the third metal pattern of the radiator and disposed in a region above the first slot region in another axial direction; a second metal plate disposed between an upper end of the first slot region in the another axial direction and a lower end of the second slot region in the another axial direction; and a third metal plate disposed in a region below the lower end of the second slot region in the another axial direction.

According to an embodiment, the first slot region may be formed to have a first width in a first region and a second width wider than the first width in a second region that is a side region rather than the first region. An end of the second slot region may be disposed in a region more inside than an end of the first slot region, and a length of the branch member may be shorter than the second length of the second slot region.

According to an embodiment, a position of an end of the PCB in the another axial direction may be lower than a position of the lower end of the second slot region. The first feeder disposed on the front surface of the PCB may be located in a region in the one axial direction more inside than the end of the second slot region.

According to an embodiment, the second feeder disposed on a rear surface of the PCB may be disposed in a side region rather than the first feeder in the one axial direction, and the antenna module may be disposed at one point of the second slot region in the one axial direction. The antenna module may further include a first ground contact portion and a second ground contact portion configured to connect the PCB and the metal plate of the bottom cover. The first ground contact portion may be disposed in a region more inside than the first feeder in the one axial direction. The second ground contact portion may be disposed in a side region rather than the second feeder in the one axial direction.

According to an embodiment, the antenna module may further include a first matching circuit connected between the first feeder and the PCB. The antenna module may further include a second matching circuit connected between the second feeder and the PCB. The first matching circuit may include a first capacitor with a serial configuration to match impedance between the radiator and the first feeder for the first signal of the first band. The second matching circuit may include a second capacitor and an inductor with serial and parallel configurations to match impedance between the second slot region and the second feeder for the second signal of the third band.

According to an embodiment, the main antenna may include a first antenna, a second antenna, a third antenna, and a fourth antenna that are disposed on top and bottom of one side and on top and bottom of another side of the bottom cover. Mold covers made of a dielectric material may be disposed on a first slot portion to a fourth slot portion corresponding to the first to fourth antennas.

A vehicle having an antenna module mounted thereon according to another aspect of the present disclosure may include an antenna module disposed below a roof of the vehicle; and a processor disposed inside or outside the antenna module, and configured to communicate with at least one of an adjacent vehicle, a road side unit (RSU), and a base station. The antenna module may include: a printed circuit board (PCB) on which electronic components are disposed; at least one radiator electrically connected to the PCB, and configured as a metal pattern having predetermined length and width to transmit and receive a first signal; a bottom cover disposed on a bottom of the PCB and configured as a metal plate with slot regions; and a top cover fastened to the bottom cover and configured to accommodate the PCB and the at least one radiator therein.

According to an embodiment, the metal plate may include: a first slot region formed on one side of the metal plate to have predetermined length and width; a second slot region formed parallel to the first slot region to have predetermined length and width; and a branch member disposed between the first slot region and the second slot region and formed of a metal plate having predetermined length and width.

According to an embodiment, the antenna module of the vehicle may further include: a first feeder disposed on a front surface of the PCB, and connected to the radiator to feed a first signal of a first band and a first signal of a second band to the radiator; and a second feeder disposed between the branch line and the metal plate forming the second slot region, and configured to feed a second signal of a third band higher than the second band to the second slot region.

According to an embodiment, the first signal may be a low band (LB) signal for 4G communication or 5G communication, the first band may be a first sub-band of the low band (LB), the second band may be a second sub-band higher than the first sub-band of the low band (LB), and the third band may be a frequency band for WiFi communication.

According to an embodiment, a first antenna, a second antenna, a third antenna, and a fourth antenna may be disposed on top and bottom of one side and on top and bottom of another side of the bottom cover, and a first slot portion to a fourth slot portion may be disposed to correspond to the first to fourth antennas. Some of the first to fourth slot portions may be configured to have a dual slot region including the first slot region, the second slot region, and the branch line, and the rest of the first to fourth slot portions may be configured to have a single slot region.

According to an embodiment, the processor may perform multi-input/multi-output (MIMO) in the low band (LB) by using two or more antennas having the dual slot region among the first antenna to the fourth antenna.

### Advantageous Effects of Invention

The technical effects of such an antenna module having a wideband antenna mounted on a vehicle and a vehicle having the antenna module will be described as follows.

According to the present disclosure, an antenna structure that operates to cover the full band of 4G/5G low band (LB) can be provided by applying a slot structure to a metal plate disposed in the lower region of a radiator.

According to the present disclosure, an antenna structure that operates even in a WiFi band in addition to a 4G/5G LB band by applying a dual slot structure to a metal plate disposed on the lower region of a radiator.

According to the present disclosure, a dual slot structure and a matching circuit can be applied to a metal plate disposed on the lower region of a radiator, thereby maintaining isolation between an antenna for MIMO and a WiFi antenna while optimizing the performances of the antennas.

According to the present disclosure, antennas can be implemented on a PCB in an antenna module and the metal plate of a bottom cover, to provide wireless signals to the inner region of a vehicle even when a vehicle body or roof is made of a metal material.

According to the present disclosure, an antenna with a slot structure can be implemented on the metal plate of a bottom cover of an antenna module, thereby providing an antenna operating in a dual mode while utilizing a ground region of a body constituting the antenna module as an antenna.

According to the present disclosure, an antenna with a slot structure can be implemented on the metal plate of a bottom cover within an antenna module, antenna performance can be improved while maintaining the height of an antenna system below a predetermined level.

According to the present disclosure, a structure for mounting an antenna system capable of operating in a wide band on a vehicle to support various communication systems can be provided.

Further scope of applicability of the present disclosure will become apparent from the following detailed description. It should be understood, however, that the detailed description and specific examples, such as the preferred embodiment of the present disclosure, are given by way of illustration only, since various modifications and alternations within the spirit and scope of the disclosure will be apparent to those skilled in the art.

### Brief Description of Drawings

FIG. 1A is a diagram illustrating an internal configuration of a vehicle in accordance with one example. FIG. 1B is a lateral view illustrating the vehicle interior in accordance with the one example.
FIG. 2A illustrates types of V2X applications.
FIG. 2B illustrates a standalone scenario supporting V2X SL communication and an MR-DC scenario supporting V2X SL communication.
FIGS. 3A to 3C are views illustrating a structure for mounting an antenna system in a vehicle, to which the antenna system is mounted.
FIG. 4 is a block diagram illustrating a vehicle and an antenna system mounted to the vehicle in accordance with one example.
FIG. 5 is an inner perspective view of an antenna module that may be disposed on a vehicle according to the present disclosure.
FIG. 6 is an inner front view of the antenna module of FIG. 5.
FIGS. 7A and 7B are a side sectional view at a first position and a second position of the antenna module of FIG. 6.
FIG. 8 illustrates a structure of a slot region formed on the metal plate of a bottom cover according to the present disclosure.
FIG. 9 is a front view of an antenna module in which a radiator is disposed on the upper region of a metal plate having a dual slot region structure according to the present disclosure.
FIG. 10 illustrates a current distribution formed on the metal plate of a bottom cover according to the present disclosure.
FIG. 11 illustrates the current distribution in a first band for the wideband antenna structure of FIG. 10.
FIG. 12 illustrates a current distribution in a second band and a mechanism thereof with respect to the wideband antenna structure of FIG. 10.
FIG. 13 illustrates a current distribution in a third band and a mechanism thereof with respect to the wideband antenna structure of FIG. 10.
FIG. 14 illustrates branch line structures according to different examples of the present disclosure.
FIG. 15 illustrates a matching circuit of a wideband antenna structure according to the present disclosure.
FIG. 16 illustrates the configuration of a matching circuit disposed between a second feeder and a slot region.
FIG. 17 illustrates 3D radiation patterns in a 2.4 GHz band and a 5.4 GHz band and left view and bottom view thereof.
FIGS. 18A and 18B illustrate slot regions formed at different positions of the metal plate of a lower cover according to embodiments.
FIG. 19A illustrates a region where a dual slot region is formed at one point of an antenna module according to the present disclosure, and a structure in which a mold cover can be coupled to the region. On the other hand, FIG. 19B is a front view of (a) of FIG. 19A, which is a state before the mold cover is coupled.
FIG. 20 is a block diagram illustrating an antenna system and a vehicle on which the antenna system is mounted according to the present disclosure.

### Mode for the Invention

Description will now be given in detail according to one or more embodiments disclosed herein, with reference to the accompanying drawings. For the sake of brief description with reference to the drawings, the same or equivalent components may be provided with the same or similar reference numbers, and a redundant description thereof will be omitted. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings. The idea of the present disclosure should be construed to extend to any alterations, equivalents and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

An antenna system described herein may be mounted on a vehicle. Configurations and operations according to implementations may also be applied to a communication system, namely, antenna system mounted on a vehicle. In this regard, the antenna system mounted in the vehicle may include a plurality of antennas, and a transceiver circuit and a processor that control the plurality of antennas.

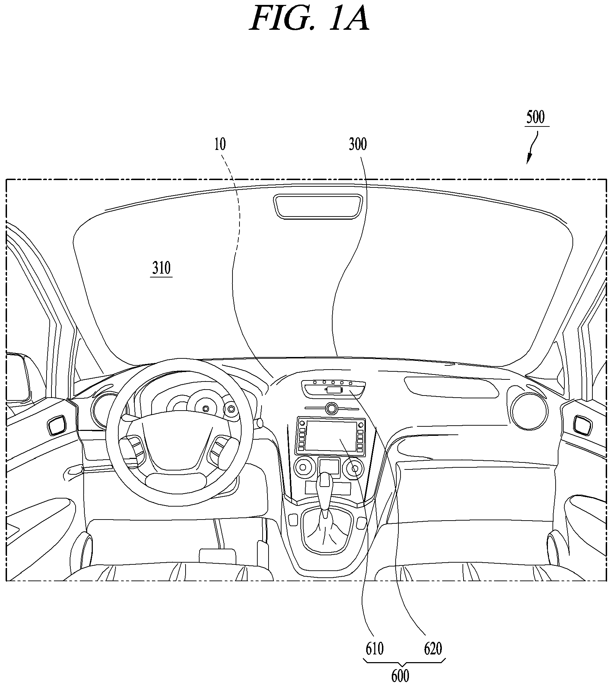

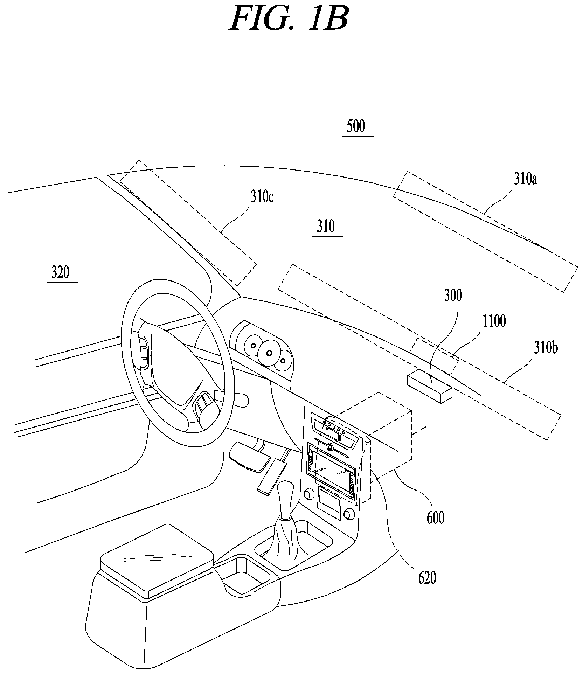

FIG. 1A is a diagram illustrating a vehicle interior in accordance with one example. FIG. 1B is a lateral view illustrating the vehicle interior in accordance with the one example.

As illustrated in FIGS. 1A and 1B, the present disclosure describes an antenna unit (i.e., an internal antenna system) 1000 capable of transmitting and receiving signals through GPS, 4G wireless communication, 5G wireless communication, Bluetooth, or wireless LAN. Therefore, the antenna unit (i.e., the antenna system) 1000 capable of supporting these various communication protocols may be referred to as an integrated antenna module 1000. The antenna system 1000 may include a telematics control unit (TCU) 300 and an antenna assembly 1100. For example, the antenna assembly 1100 may be disposed on a window of a vehicle.

The present disclosure also describes a vehicle 500 having the antenna system 1000. The vehicle 500 may include a dashboard and a housing 10 including the telematics control unit (TCU) 300, and the like. In addition, the vehicle 500 may include a mounting bracket for mounting the telematics control unit (TCU) 300.

The vehicle 500 may include the telematics control unit (TCU) 300 and an infotainment unit 600 configured to be connected to the telematics control unit 300. A portion of a front pattern of the infotainment unit 600 may be implemented in the form of a dashboard of the vehicle. A display 610 and an audio unit 620 may be included in the dashboard of the vehicle.

The antenna assembly 1100, namely, the antenna module 1100 in the form of a transparent antenna may be disposed at at least one of an upper region 31 0a, a lower region 310b, and a side region 310c of a front window 310. The antenna assembly 1100 may also be disposed at a side window 320, which is disposed at a side surface of the vehicle, in addition to the front window 310.

As illustrated in FIG. 1B, when the antenna assembly 1100 is disposed at the lower region 310b of the front window 310, it may be operably coupled to a TCU 300 disposed inside the vehicle. When the antenna assembly 1100 is disposed at the upper region 310a or the side region 310c of the front window 310, it may be operably coupled to a TCU disposed outside the vehicle. However, the present disclosure may not be limited to the TCU coupling configuration inside or outside the vehicle.

### <V2X (Vehicle-to-Everything)>

V2X communication may include communications between a vehicle and all entities, such as V2V (Vehicle-to-Vehicle) which refers to communication between vehicles, V2I (Vehicle-to-Infrastructure) which refers to communication between a vehicle and an eNB or RSU (Road Side Unit), V2P (Vehicle-to-Pedestrian) which refers to communication between a vehicle and a terminal possessed by a person (pedestrian, cyclist, vehicle driver, or passenger), V2N (vehicle-to-network), and the like.

V2X communication may have the same meaning as V2X sidelink or NR V2X or may have, in a broader sense, a meaning including V2X sidelink or NR V2X.

V2X communication can be applied to various services, for example, forward collision warning, an automatic parking assist system, cooperative adaptive cruise control (CACC), control-loss warning, traffic queuing warning, safety warning, traffic vulnerable-area safety warning, emergency vehicle warning, curved-road driving speed warning, and traffic flow control.

V2X communication may be provided through a PC5 interface and/or a Uu interface. In this case, specific network entities for supporting communications between a vehicle and all entities may exist in a wireless communication system supporting V2X communication. For example, the network entity may include a base station (eNB), a Road Side Unit (RSU), a terminal, or an application server (e.g., a traffic safety server).

In addition, a terminal performing V2X communication may refer to not only a general handheld UE but also a vehicle (V-UE), a pedestrian UE, an RSU of an eNB type, an RSU of a UE type, a robot equipped with a communication module, and the like.

V2X communication may be performed directly between terminals or may be performed through the network entity (entities). V2X operation modes may be classified according to a method of performing such V2X communication.

Terms used in V2X communication may be defined as follows.

A Road Side Unit (RSU) is a V2X service enabled device that can transmit and receive data to and from a moving vehicle using V2I service. The RSU also serves as a stationary infrastructure entity that supports V2X application programs, and may exchange messages with other entities that support V2X application programs. The RSU is a term frequently used in existing ITS specifications, and the reason for employing the term RSU in association with the 3GPP specifications is to read relevant documents in an easier manner in the ITS industry. The RSU is a logical entity that combines a V2X application logic with the functionality of an eNB (referred to as an eNB-type RSU) or a UE (referred to as a UE-type RSU).

V2I Service is a type of V2X service, where one party is a vehicle whereas the other party is an entity belonging to infrastructure. V2P Service is also a type of V2X service, where one party is a vehicle and the other party is a device carried by an individual (e.g., a handheld terminal carried by a pedestrian, a cyclist, a driver, or a passenger). V2X Service is a type of 3GPP communication service that involves a transmitting or receiving device on a vehicle. Based on the other party involved in the communication, it may be further divided into V2V service, V2I service and V2P service.

V2X enabled UE is a UE that supports V2X service. V2V Service is a type of V2X service, where both parties of communication are vehicles. V2V communication range is a direct communication range between two vehicles engaged in V2V service.

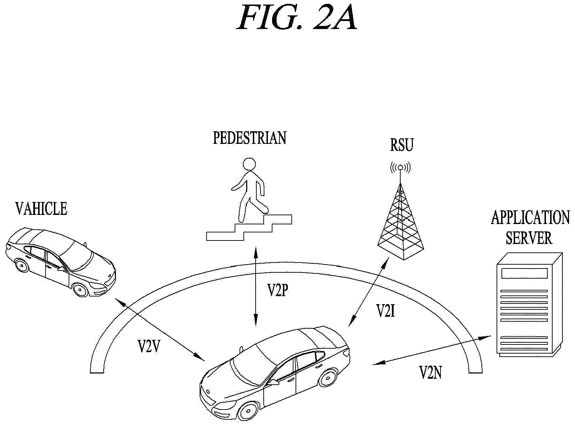

V2X applications, referred to as Vehicle-to-Everything (V2X), include the four different types, as described above, namely, (1) vehicle-to-vehicle (V2V), (2) vehicle-to-infrastructure (V2I), (3) vehicle-to-network (V2N), (4) vehicle-to-pedestrian (V2P). FIG. 2A illustrates types of V2X applications. Referring to FIG. 2A, the four types of V2X applications may use "cooperative awareness" to provide more intelligent services for end-users.

This means that, in order to provide more intelligent information, such as cooperative collision warning or autonomous traveling, entities, such as vehicles, roadside-based facilities, application servers and pedestrians, may collect knowledge of involved local environments (e.g., information received from nearby vehicles or sensor equipment) to process and share the corresponding knowledge.

### <NR V2X>

In 3GPP Releases 14 and 15, support of the V2V and V2X services in LTE has been introduced in order to extend the 3GPP platform to the automotive industry.

Requirements for support of enhanced V2X use cases are largely organized into four use case groups.
(1) Vehicles Platooning enables the vehicles to dynamically form a platoon traveling together. All the vehicles in the platoon obtain information from the leading vehicle to manage this platoon. These information allow the vehicles to drive closer than normal in a coordinated manner, going to the same direction and traveling together.
(2) Extended Sensors enable the exchange of raw or processed data gathered through local sensors or live video images among vehicles, road site units, devices of pedestrians and V2X application servers. The vehicle can recognize an environment much more than through detection by its sensor and can recognize a local situation as a whole in a more extensive manner. A high data transmission rate is one of primarily features of the extended sensor.
(3) Advanced Driving enables semi-automatic or fully-automatic driving. The advanced driving enables each vehicle and/or each RSU to share self-recognition data obtained from a local sensor with a nearby vehicle and to synchronize and adjust a trajectory or a maneuver. Each vehicle shares its intention to drive with a nearby vehicle.
(4) Remote driving serves to enable a remote driver or a V2X application program to drive a remotely-located vehicle in a dangerous environment by him/herself or itself or instead of an occupant who cannot drive the remotely-located vehicle. In a case where a traffic environment is limitedly changed and a vehicle driving path is predictable such as in public transportation, driving based on cloud computing may be available. High reliability and low latency are main requirements for the remote driving.

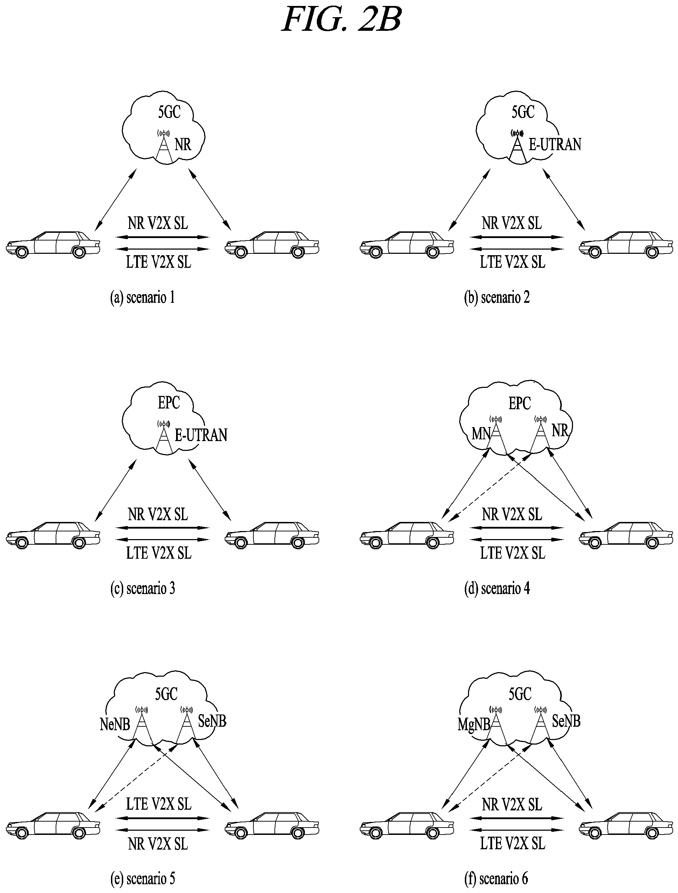

A description to be given below may be applicable to all of NR SL (sidelink) and LTE SL, and when no radio access technology (RAT) is indicated, the NR SL is meant. Six operational scenarios considered in NR V2X may be considered as follows. In this regard, FIG. 2B illustrates a standalone scenario supporting V2X SL communication and an MR-DC scenario supporting V2X SL communication.

In particular, 1) in Scenario 1, gNB provides control/configuration for UE's V2X communication in both LTE SL and NR SL. 2) In Scenario 2, ng-eNB provides control/configuration for UE's V2X communication in both LTE SL and NR SL. 3) In Scenario 3, eNB provides control/configuration for UE's V2X communication in both LTE SL and NR SL. On the other hand, 4) in Scenario 4, the UE's V2X communication in the LTE SL and the NR SL is controlled/configured by Uu while the UE is configured with EN-DC. 5) In Scenario 5, the UE's V2X communication in the LTE SL and the NR SL is controlled/configured by Uu while the UE is configured in NE-DC. 6) In Scenario 6, the UE's V2X communication in the LTE SL and the NR SL is controlled/configured by Uu while the UE is configured in NGEN-DC.

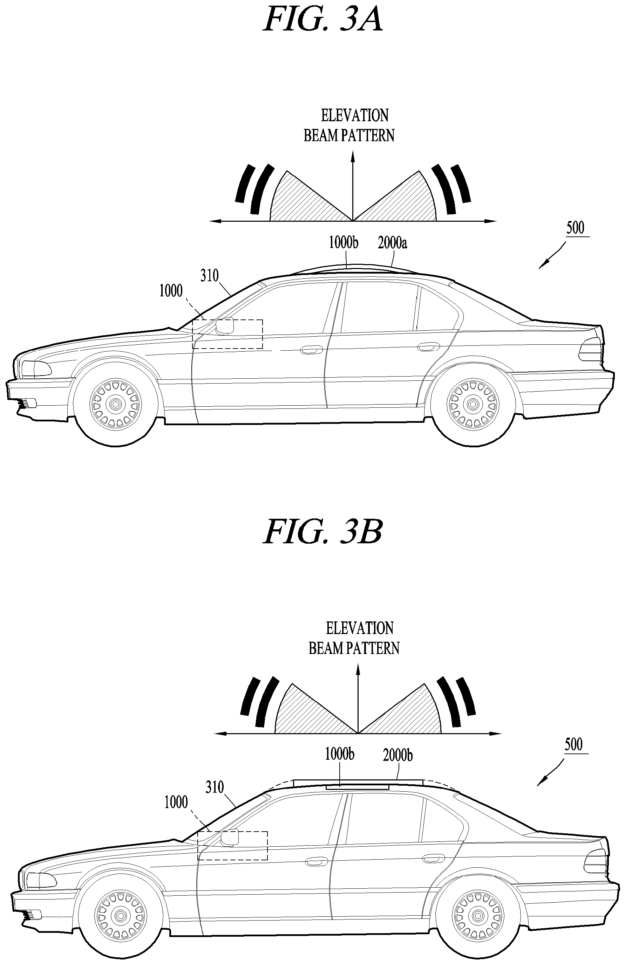

In order to support the V2X communication, as illustrated in FIGS. 2A and 2B, the vehicle may perform wireless communication with eNB and/or gNB through an antenna system. The antenna system may be configured as an internal antenna system as illustrated in FIGS. 1A and 1B. The antenna system may alternatively be implemented as an external antenna system and/or an internal antenna system as illustrated in FIGS. 3A to 3C.

FIGS. 3A to 3C are views illustrating an example of a structure for mounting an antenna system on a vehicle, which includes the antenna system mounted on the vehicle. In this regard, FIGS. 3A to 3C illustrate a configuration capable of performing wireless communication through a transparent antenna disposed on the front window 310 of the vehicle. An antenna system 1000 including a transparent antenna may be disposed on a front window of a vehicle and inside the vehicle. Wireless communication may also be performed through a transparent antenna disposed on a side glass of the vehicle, in addition to the front window.

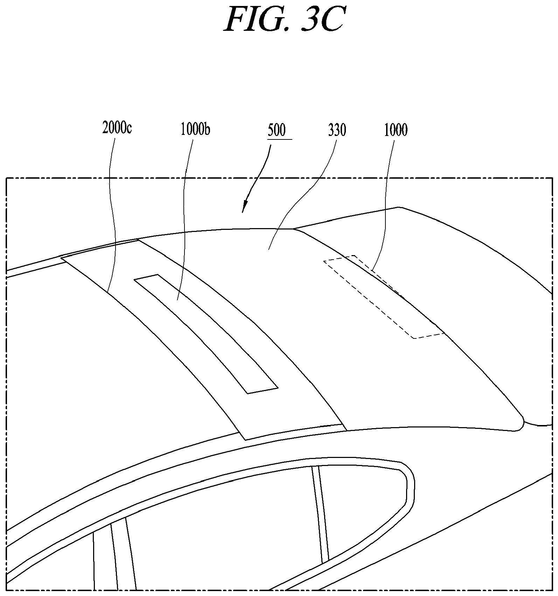

The antenna system for the vehicle that includes the transparent antenna can be combined with other antennas. Referring to FIGS. 3A to 3C, in addition to the antenna system 1000 implemented as the transparent antenna, a separate antenna system 1000b may be further configured. FIGS. 3A and 3B illustrate a structure in which the antenna system 1000b, in addition to the antenna system 1000, is mounted on or in a roof of the vehicle. On the other hand, FIG. 3C illustrates a structure in which the separate antenna system 1000b, in addition to the antenna system 1000, is mounted in a roof frame of a roof and a rear mirror of the vehicle.

Referring to FIGS. 3A to 3C, in order to improve the appearance of the vehicle and to maintain a telematics performance at the time of collision, an existing shark fin antenna may be replaced with a flat antenna of a non-protruding shape. In addition, the present disclosure proposes an integrated antenna of an LTE antenna and a 5G antenna considering fifth generation (5G) communication while providing the existing mobile communication service (e.g., LTE).

Referring to FIG. 3A, the antenna system 1000 implemented as the transparent antenna may be disposed on the front window 310 of the vehicle and inside the vehicle. The second antenna system 1000b corresponding to an external antenna may be disposed on the roof of the vehicle. In FIG. 3A, a radome 2000a may cover the second antenna system 1000b to protect the second antenna system 1000b from an external environment and external impacts while the vehicle travels. The radome 2000a may be made of a dielectric material through which radio signals are transmitted/received between the second antenna system 1000b and a base station.

Referring to FIG. 3B, the antenna system 1000 implemented as the transparent antenna may be disposed on the front window 310 of the vehicle and inside the vehicle. One the other hand, the second antenna system 1000b corresponding to the external antenna may be disposed within a roof structure of the vehicle and at least part of the roof structure 2000b may be made of a non-metallic material. At this time, the roof structure 2000b of the vehicle except for the at least part made of the non-metallic material may be made of a dielectric material through which radio signals are transmitted/received between the antenna system 1000b and the base station.

Referring to FIG. 3C, the antenna system 1000 implemented as the transparent antenna may be disposed on the rear window 330 of the vehicle and inside the vehicle. The second antenna system 1000b corresponding to the external antenna may be disposed within the roof frame 2000c of the vehicle, and at least part of the roof frame 2000c may be made of a non-metallic material. At this time, the roof frame 2000c of the vehicle 500 except for the at least part made of the non-metallic material may be made of a dielectric material through which radio signals are transmitted/received between the second antenna system 1000b and the base station.

Referring to FIGS. 3A to 3C, antennas provided in the antenna system 1000 mounted on the vehicle may form a beam pattern in a direction perpendicular to the front window 310 or the rear window 330. Antenna provided in the second antenna system 1000 mounted on the vehicle may further define a beam coverage by a predetermined angle in a horizontal region with respect to the vehicle body.

Meanwhile, the vehicle 500 may include only the antenna unit (i.e., the internal antenna system) 1000 corresponding to the internal antenna without the antenna system 1000b corresponding to the external antenna.

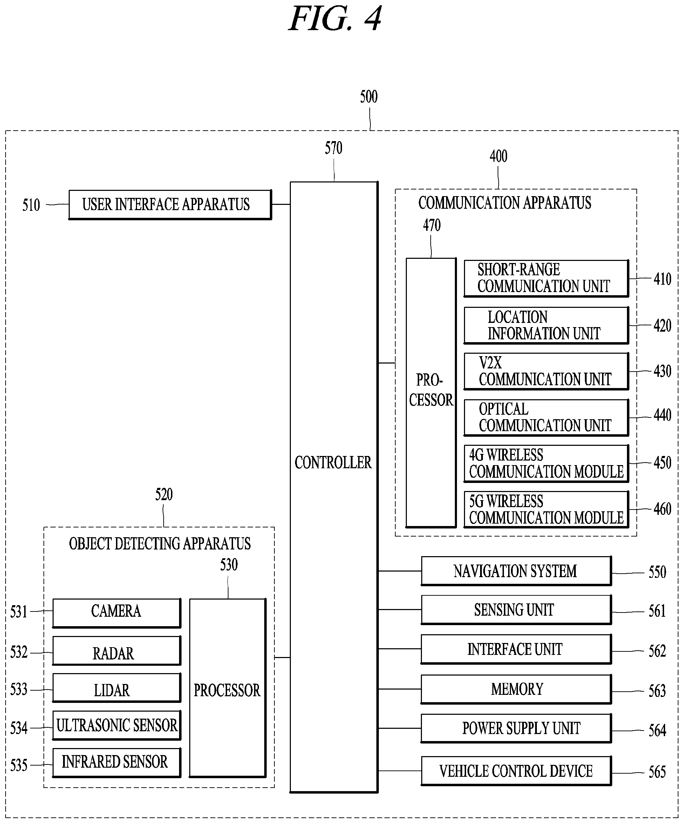

Meanwhile, FIG. 4 is a block diagram illustrating a vehicle and an antenna system mounted on the vehicle in accordance with an implementation.

The vehicle 500 may be an autonomous (driving) vehicle. The vehicle 500 may be switched into an autonomous driving mode or a manual mode (a pseudo driving mode) based on a user input. For example, the vehicle 500 may be switched from the manual mode into the autonomous mode or from the autonomous mode into the manual mode based on a user input received through a user interface apparatus 510.

In relation to the manual mode and the autonomous driving mode, operations such as object detection, wireless communication, navigation, and operations of vehicle sensors and interfaces may be performed by the telematics control unit mounted on the vehicle 500. Specifically, the telematics control unit mounted on the vehicle 500 may perform the operations in cooperation with the antenna module 300, the object detecting apparatus 520, and other interfaces. In some examples, the communication apparatus 400 may be disposed in the telematics control unit separately from the antenna system 300 or may be disposed in the antenna system 300.

The vehicle 500 may be switched into the autonomous mode or the manual mode based on driving environment information. The driving environment information may be generated based on object information provided by the object detecting apparatus 520. For example, the vehicle 500 may be switched from the manual mode into the autonomous driving mode or from the autonomous driving mode into the manual mode based on driving environment information generated in the object detecting apparatus 520.

For example, the vehicle 500 may be switched from the manual mode into the autonomous driving mode or from the autonomous driving mode into the manual mode based on driving environment information received through the communication apparatus 400. The vehicle 500 may be switched from the manual mode into the autonomous driving mode or from the autonomous driving mode into the manual mode based on information, data or signal provided by an external device.

When the vehicle 500 travels in the autonomous mode, the autonomous vehicle 500 may travel under the control of an operation system. For example, the autonomous vehicle 500 may travel based on information, data or signal generated in a driving system, a parking exit (parking-lot leaving system, and a parking system. When the vehicle 500 is driven in the manual mode, the autonomous vehicle 500 may receive a user input for driving through a driving control apparatus. The vehicle 500 may travel based on the user input received through the driving control apparatus.

The vehicle 500 may include a user interface device 510, an object detection device 520, a navigation system 550, and a communication device 400. The vehicle may further include a sensing unit 561, an interface unit 562, a memory 563, a power supply unit 564, and a vehicle control device 565 in addition to the aforementioned apparatuses and devices. According to embodiments the vehicle 500 may include more components in addition to components to be explained in this specification or may not include some of those components to be explained in this specification.

The user interface apparatus 510 may be an apparatus for communication between the vehicle 500 and a user. The user interface apparatus 510 may receive a user input and provide information generated in the vehicle 500 to the user. The vehicle 500 may implement user interfaces (Uls) or user experiences (UXs) through the user interface apparatus 510.

The object detecting apparatus 520 may be a device for detecting an object located at outside of the vehicle 500. The object may be a variety of things associated with driving (operation) of the vehicle 500. In some examples, objects may be classified into moving objects and fixed (stationary) objects. For example, the moving objects may include other vehicles and pedestrians. The fixed objects may conceptually include traffic signals, roads, and structures, for example. The object detecting apparatus 520 may include a camera 521, a radar 522, a LiDAR 523, an ultrasonic sensor 524, an infrared sensor 525, and a processor 530. In some implementations, the object detecting apparatus 520 may further include other components in addition to the components described, or may not include some of the components described.

The processor 530 may control an overall operation of each unit of the object detecting apparatus 520. The processor 530 may detect an object based on an acquired image, and track the object. The processor 530 may execute operations, such as computing of a distance to the object, computing of a relative speed with respect to the object and the like, through an image processing algorithm.

According to an embodiment, the object detecting apparatus 520 may include a plurality of processors 530 or may not include any processor 530. For example, each of the camera 521, the radar 522, the LiDAR 523, the ultrasonic sensor 524 and the infrared sensor 525 may include the processor in an individual manner.

When the processor 530 is not included in the object detecting apparatus 520, the object detecting apparatus 520 may operate according to the control of a processor of an apparatus within the vehicle 500 or the controller 570.

The navigation system 550 may provide location information related to the vehicle based on information obtained through the communication apparatus 400, in particular, a location information unit 420. Also, the navigation system 550 may provide a path (or route) guidance service to a destination based on current location information related to the vehicle. In addition, the navigation system 550 may provide guidance information related to surroundings of the vehicle based on information obtained through the object detecting apparatus 520 and/or a V2X communication unit 430. In some examples, guidance information, autonomous driving service, etc. may be provided based on V2V, V2I, and V2X information obtained through a wireless communication unit operating together with the antenna system 1000.

The communication apparatus 400 may be an apparatus for performing communication with an external device. Here, the external device may be another vehicle, a mobile terminal, or a server. The communication apparatus 400 may perform the communication by including at least one of a transmitting antenna, a receiving antenna, and radio frequency (RF) circuit and RF device for implementing various communication protocols. The communication device 400 may include a short-range communication unit 410, a location information unit 420, a V2X communication unit 430, an optical communication unit 440, a broadcast transceiver 450 and a processor 470. According to an embodiment, the communication apparatus 400 may further include other components in addition to the components described, or may not include some of the components described.

The short-range communication unit 410 is a unit for facilitating short-range communications. The short-range communication unit 410 may construct short-range wireless area networks to perform short-range communication between the vehicle 500 and at least one external device. The location information unit 420 may be a unit for acquiring location information related to the vehicle 500. For example, the location information unit 420 may include a Global Positioning System (GPS) module or a Differential Global Positioning System (DGPS) module.

The V2X communication unit 430 may be a unit for performing wireless communication with a server (Vehicle to Infrastructure; V2I), another vehicle (Vehicle to Vehicle; V2V), or a pedestrian (Vehicle to Pedestrian; V2P). The V2X communication unit 430 may include an RF circuit in which protocols for communication with an infrastructure (V2I), communication between vehicles (V2V), and communication with a pedestrian (V2P) are executable. The optical communication unit 440 may be a unit for performing communication with an external device through the medium of light. The optical communication unit 440 may include a light-emitting diode for converting an electric signal into an optical signal and sending the optical signal to the exterior, and a photodiode for converting the received optical signal into an electric signal. According to an embodiment, the optical transmission part may be formed integrally with lamps provided on the vehicle 500.

The wireless communication unit 460 is a unit that performs wireless communication with one or more communication systems through one or more antenna systems. The wireless communication unit 460 may transmit and/or receive a signal to and/or from a device in a first communication system through a first antenna system. In addition, the wireless communication unit may transmit and/or receive a signal to and/or from a device in a second communication system through a second antenna system. For example, the first communication system and the second communication system may be an LTE communication system and a 5G communication system, respectively. However, the first communication system and the second communication system may not be limited thereto, and may be changed according to applications.

In some examples, the antenna module 300 disposed in the vehicle 500 may include a wireless communication unit. In this regard, the vehicle 500 may be an electric vehicle (EV) or a vehicle that can be connected to a communication system independently of an external electronic device. In this regard, the communication apparatus 400 may include at least one of the short-range communication unit 410, the location information unit 420, the V2X communication unit 430, the optical communication unit 440, a 4G wireless communication module 450, and a 5G wireless communication module 460.

The 4G wireless communication module 450 may perform transmission and reception of 4G signals with a 4G base station through a 4G mobile communication network. In this case, the 4G wireless communication module 450 may transmit at least one 4G transmission signal to the 4G base station. In addition, the 4G wireless communication module 450 may receive at least one 4G reception signal from the 4G base station. In this regard, Uplink (UL) Multi-input/Multi-output (MIMO) may be performed by a plurality of 4G transmission signals transmitted to the 4G base station. In addition, Downlink (DL) MIMO may be performed by a plurality of 4G reception signals received from the 4G base station.

The 5G wireless communication module 460 may perform transmission and reception of 5G signals with a 5G base station through a 5G mobile communication network. Here, the 4G base station and the 5G base station may have a Non-Stand-Alone (NSA) architecture. The 4G base station and the 5G base station may be disposed in the Non-Stand-Alone (NSA) architecture. Alternatively, the 5G base station may be installed stand-alone (SA: It can be deployed in a Stand-Alone structure. The 5G wireless communication module 460 may perform transmission and reception of 5G signals with a 5G base station through a 5G mobile communication network. In this case, the 5G wireless communication module 460 may transmit at least one 5G transmission signal to the 5G base station. In addition, the 5G wireless communication module 460 may receive at least one 5G reception signal from the 5G base station. In this instance, a 5G frequency band that is the same as a 4G frequency band may be used, and this may be referred to as LTE re-farming. In some examples, a Sub6 frequency band, which is a range of 6 GHz or less, may be used as the 5G frequency band. In contrast, a millimeter-wave (mmWave) band may be used as the 5G frequency band to perform wideband high-speed communication. When the mmWave band is used, the electronic device may perform beamforming for coverage expansion of an area where communication with a base station is possible.

Regardless of the 5G frequency band, in the 5G communication system, Multi-Input Multi-Output (MIMO) may be supported to be performed multiple times, in order to improve a transmission rate. In this instance, UL MIMO may be performed by a plurality of 5G transmission signals that are transmitted to a 5G base station. In addition, DL MIMO may be performed by a plurality of 5G reception signals that are received from the 5G base station.

In some examples, A state of dual connectivity (DC) to both the 4G base station and the 5G base station may be attained through the 4G wireless communication module 450 and the 5G wireless communication module 460. As such, the dual connectivity to the 4G base station and the 5G base station may be referred to as EUTRAN NR DC (EN-DC). When the 4G base station and 5G base station are disposed in a co-located structure, throughput improvement may be achieved by inter-Carrier Aggregation (inter-CA). Therefore, when the 4G base station and the 5G base station are disposed in the EN-DC state, the 4G reception signal and the 5G reception signal may be simultaneously received through the 4G wireless communication module 450 and the 5G wireless communication module 460, respectively. Short-range communication between electronic devices (e.g., vehicles) may be performed between electronic devices (e.g., vehicles) using the 4G wireless communication module 450 and the 5G wireless communication module 460. In one embodiment, after resources are allocated, vehicles may perform wireless communication in a V2V manner without a base station.

Meanwhile, for transmission speed improvement and communication system convergence, carrier aggregation (CA) using at least one of the 4G wireless communication module 450 and 5G wireless communication module 460 and the Wi-Fi communication module 113. In this regard, 4G + WiFi carrier aggregation (CA) may be performed using the 4G wireless communication module 450 and the Wi-Fi communication module 113. Or, 5G + WiFi CA may be performed using the 5G wireless communication module 460 and the Wi-Fi communication module.

In some examples, the communication apparatus 400 may implement a display apparatus for a vehicle together with the user interface apparatus 510. In this instance, the display apparatus for the vehicle may be referred to as a telematics apparatus or an Audio Video Navigation (AVN) apparatus.

The processor 470 of the communication apparatus 400 may correspond to a modem. In this regard, the RFIC and the modem may be referred to as a first controller (or a first processor) and a second controller (a second processor), respectively. Meanwhile, the RFIC and the modem may be implemented as physically separate circuits. Alternatively, the RFIC and the modem may be logically or functionally separated from each other on one physical circuit. The modem may perform control and signal processing for signal transmission and reception through different communication systems using the RFID. The modem 1400 may acquire control information from a 4G base station and/or a 5G base station. Here, the control information may be received through a physical downlink control channel (PDCCH), but may not be limited thereto.

The modem may control the RFIC 1250 to transmit and/or receive signals through the first communication system and/or the second communication system for a specific time interval and from frequency resources. Accordingly, the vehicle can be allocated resources or maintain a connected state through the eNB or gNB. In addition, the vehicle may perform at least one of V2V communication, V2I communication, and V2P communication with other entities using the allocated resources.

Meanwhile, referring to FIGS. 1A to 4, the antenna module mounted on the vehicle may be disposed inside the vehicle, on the roof of the vehicle, inside the roof, or inside the roof frame. In this regard, the antenna system disclosed herein may be configured to operate in a low band (LB), mid band (MB), and high band (HB) of a 4G LTE system and a SUB6 band of a 5G NR system. Additionally, the antenna system disclosed in the present disclosure may be configured to operate in a 2.4 GHz band and a 5.44 GHz band for Wi-Fi communication services.

Hereinafter, a wideband antenna structure for a vehicle according to the present disclosure will be described. In this regard, a wideband antenna structure for a vehicle may be implemented through a slot antenna technology designed for two independent antennas. Meanwhile, the wideband antenna structure for a vehicle may be implemented by applying a technology for designing an antenna using a metal case as a bottom surface of a device to radiate signals to the inner region of the vehicle in addition to the outer region of the vehicle. To this end, a slot may be formed on a metal case, but a slot structure may be optimized for the Wi-Fi communication band in addition to the 4G/5G communication band.

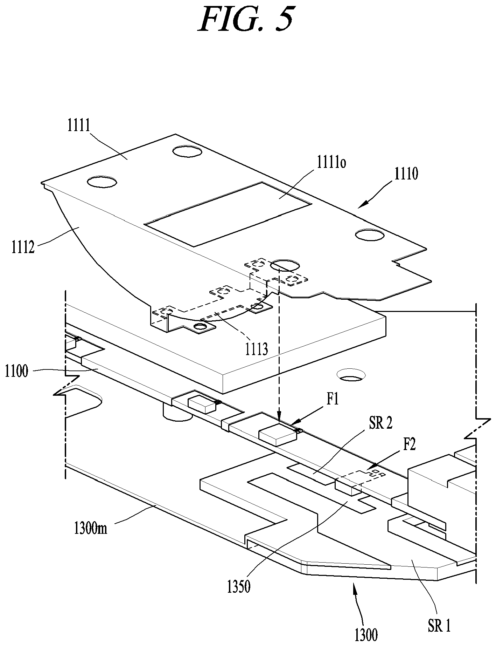

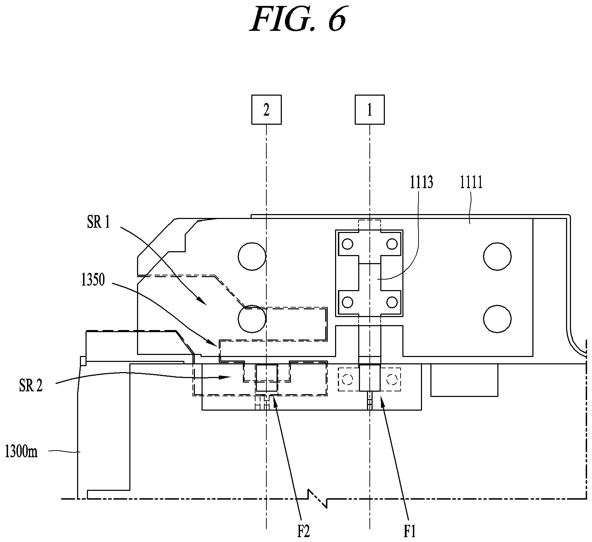

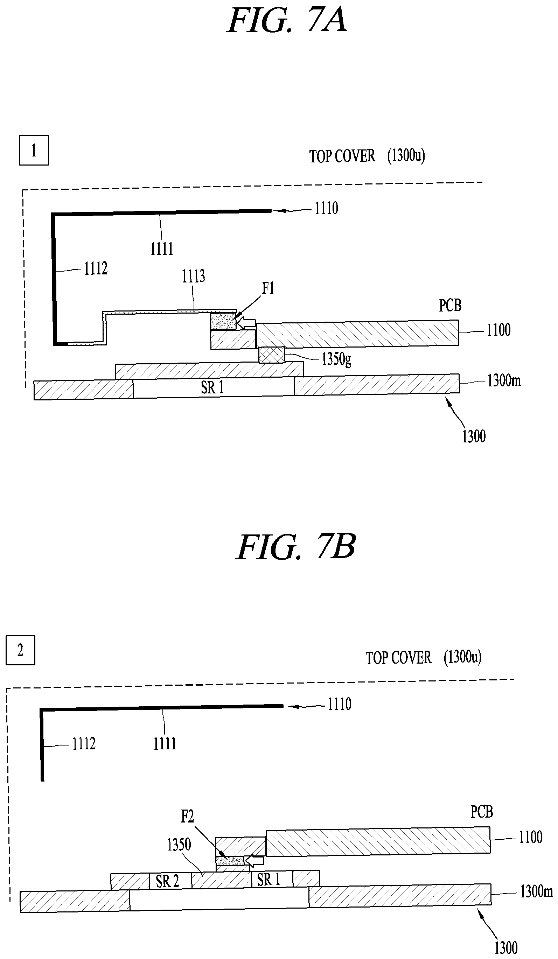

FIG. 5 is an inner perspective view of an antenna module that may be disposed on a vehicle according to the present disclosure. On the other hand, FIG. 6 is an inner front view of the antenna module of FIG. 5. Also, FIGS. 7A and 7B are a side sectional view at a first position and a second position of the antenna module of FIG. 6.

In this regard, a slot structure may be formed as a single slot structure in a shape like "⊂". The slot structure according to the present disclosure may be formed as a dual slot structure in a shape like "∈," so as to operate in a dual mode to cover the Wi-Fi communication band in addition to the 4G/5G communication band. Therefore, the wideband antenna structure according to the present disclosure adopts a technology of designing an antenna to operate as two independent antennas. In this regard, if two antennas are implemented by the slot shaped like " ⊂," interference between the antennas may occur. In addition, if two separate antenna structures are adopted, separate antenna patterns need to be added to set resonant frequencies differently, thereby increasing an antenna space.

Therefore, the present disclosure is directed to proposing a method of designing an additional antenna without an increase in antenna space by additionally generating the resonance mode of the antenna in a limited space. Additionally, the present disclosure desires to apply a dual slot structure to the metal plate of a bottom cover to minimize the increase in costs due to the implementation of the additional antenna.

To this end, the wideband antenna structure proposed in the present disclosure adopts a technology for implementing a separate antenna by changing the shape of a slot structure. Therefore, the wideband antenna structure proposed in the present disclosure has a differential point in view of a dual slot structure, and the antenna implemented by this dual slot structure has the characteristic of operating even in a band of 1 GHz or higher in addition to a band of 1 GHz or lower. In this regard, since the fundamental mode of a slot operates in a low frequency band, an additionally implemented slot antenna needs a structure to block signals in the 1 GHz band.

The present disclosure is directed to providing an antenna structure operating to cover a full band of 4G/5G low band (LB) through such wideband antenna structure. The present disclosure is also directed to providing an antenna structure operating even in a WiFi band in addition to a 4G/5G LB band.

The present disclosure is directed to providing a configuration capable of maintaining isolation between an antenna for multi-input/multi-output (MIMO) and a WiFi antenna while optimizing antenna performances therefor. The present disclosure is directed to providing a wireless signal to the inner region of a vehicle even in case where the exterior of a vehicle body or roof is made of a metal material.

The present disclosure is directed to providing an antenna operating in a dual mode while using a ground region of a body, which constitutes an antenna module, as an antenna. The present disclosure is directed to implementing antenna performance of an antenna system while maintaining a height of the antenna system at a predetermined level or less. The present disclosure is directed to providing a structure for mounting an antenna system, which is capable of operating in a wide frequency band to support various communication systems, to a vehicle.

In this regard, the antenna module mounted on the vehicle may be configured to include a PCB 1100, a radiator 1110, a bottom cover 1300, and a top cover 1300u. Electronic components may be disposed on the PCB 1100. A PCB on which an antenna element such as the radiator 1110 may be disposed may be referred to as an antenna PCB 1100.

The radiator 1110 may be configured to be electrically connected to the PCB 1100 through a side region (side surface region). The radiator 1110 may be formed as a metal pattern with predetermined length and width and configured to transmit and receive a first signal of a first band. In this regard, the first signal may be an LB signal for 4G communication or 5G communication. The first band may be a first sub-band of the LB band and may be about 700 MHz, but is not limited thereto. The radiator 1110 may be a monopole radiator that operates as an antenna with an electrical length of about 1/4 wavelength of an operating frequency band, but is not limited thereto.

The bottom cover 1300 may be disposed below the PCB 1100 and may be configured as a metal plate having slots regions SR1 and SR2. The top cover 1300u may be fastened to the bottom cover 1300 to accommodate the PCB 1100 and the radiator 1110 therein.

The metal plate 1300m of the bottom cover 1300 may include a first slot region SR1, a second slot region SR2, and a branch member 1350. The first slot region SR1 may be formed to have predetermined length and width on one side of the metal plate 1300m. The second slot region SR2 may be formed to have predetermined length and width to be parallel to the first slot region SR1. The branch member 1350 may be a metal plate having predetermined length and width and may be disposed between the first slot region SR1 and the second slot region SR2. The first slot region SR1 may be referred to as a MIMO slot because it constitutes a radiator that performs MIMO through 4G/5G wireless communication. The second slot region SR2 may be referred to as a WiFi slot because it constitutes a radiator for Wi-Fi wireless communication.

With reference to the above-described technical features, the main subject matter of the wideband antenna structure according to the present disclosure may be summarized as follows. In a hybrid radiator structure of a monopole radiator + a slot radiator, a branch conductive member may be provided inside a slot to form a dual slot structure. The monopole radiator may operate as an antenna in the first band through a direct feeder corresponding to a first feeder, which is disposed on the metal plate with the dual slot structure. A partial slot region of the dual slot structure may operate as an antenna in a second band through the direct feeder corresponding to the first feeder. On the other hand, the slot region may operate as an antenna in a third band through an indirect feeder corresponding to a second feeder, which is disposed in the slot region where the dual slot structure is implemented. The wideband antenna can be implemented by a slot share structure by the first feeder and the second feeder corresponding to the direct feeder and the indirect feeder.

Additionally, the antenna module may be configured to include a first feeder F1. The first feeder F1 may be disposed on the front surface of the PCB 1100. The first feeder F1 may be connected to the radiator 1110 to feed the first signal of the first band to the radiator. Additionally, the first feeder F1 may be connected to the radiator 1110 to feed the first signal of the second band to the slot regions SR1 and SR2. Additionally, the PCB 1100 may be connected to the bottom cover 1300 through a ground contact portion 1350g. Accordingly, the first feeder F1 may be referred to as a MIMO feeder that is configured to perform MIMO in the first band or the second band.

As described above, the first signal may be an LB signal for 4G communication or 5G communication. The second band may be a second sub-band of the LB band that is higher than the first sub-band and may be about 920 MHz, but is not limited thereto.

The radiator 1100 configured to radiate the first signal of the first band and the slot regions SR1 and SR2 of the metal plate 1300m configured to radiate the first signal of the second band may constitute a main antenna. The main antenna may be configured to operate in the LB band of the 4G communication or 5G communication bands.

The antenna module may further include a second feeder F2. The second feeder F2 may be configured to be disposed between the branch line 1350 and the metal plate forming the second slot region SR2. The second feeder F2 may be configured to feed a second signal of a third band higher than the second band to the second slot region SR2. The third band may be a frequency band for WiFi communication, and the second signal may be a WiFi signal. Accordingly, the second slot region SR2 configured to radiate the second signal of the third band may configure a WiFi antenna operating in the WiFi frequency band. Accordingly, the second feeder F2 may be referred to as a WiFi feeder configured to apply a WiFi signal in the third band.

The radiator 1110 may be configured to include a first metal pattern 1111 corresponding to an upper metal pattern and a second metal pattern 1112 corresponding to a side metal pattern. The radiator 1110 may be configured to further include a third metal pattern 1113 corresponding to a lower metal pattern.

The first metal pattern 1111 may be disposed parallel to the top cover. An opening region 1111o may be formed in the first metal pattern 1111. As a current path is increased by the opening region 1111o, the radiator 1100 may operate in a lower frequency band.

The second metal pattern 1112 may be vertically connected to the first metal pattern 1111 to form a side region (side surface region). The third metal pattern 1113 may be configured to be connected to the second metal pattern 1112 and the first feeder F1. The third metal pattern 1113 may be configured to transmit the first signal of the first band to the second metal pattern 1112, which is the side metal pattern.

As the radiator 1110 operates as a first radiator and the slot regions SR1 and SR2 operate as a second radiator, the main antenna may resonate in a wide band over the full LB band. Accordingly, the main antenna may operate in a dual mode in which it operates as a first radiator in the first band and as a second radiator in the second band, thereby operating as a wideband antenna over the full LB band.

In this regard, the radiator 1110 operates as a first radiator that radiates the first signal of the first band fed from the first feeder F1. On the other hand, the slot regions SR1 and SR2 operate as a second radiator that radiates the first signal of the second band fed from the second feeder F2. Accordingly, the first radiator operating in the first band and the second radiator operating in the second band constitute the main antenna.

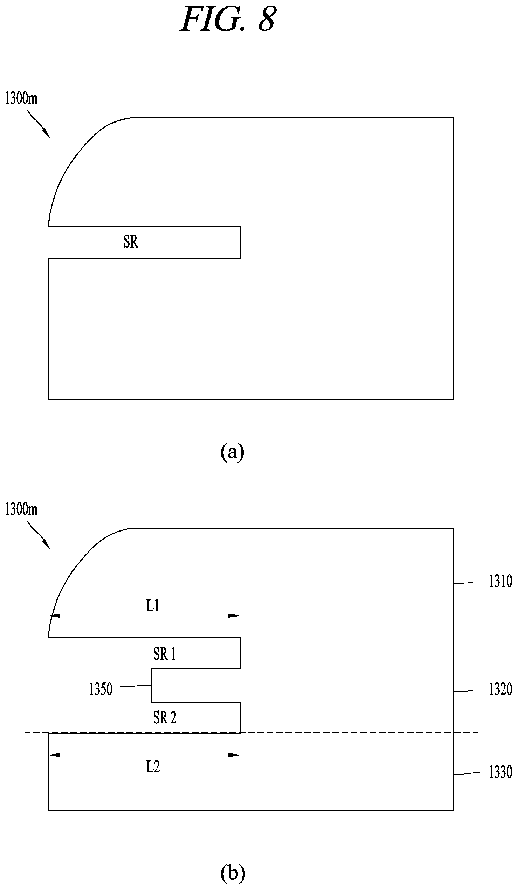

Meanwhile, the antenna module including the wideband radiator described herein may optimize antenna performance by forming various slot regions on the metal plate of the bottom cover. In this regard, FIG. 8 illustrates a structure of a slot region formed on the metal plate of a bottom cover according to the present disclosure. (a) of FIG. 8 illustrates a structure in which a single slot region SR is formed on the metal plate 1300m of the bottom cover. On the other hand, (b) of FIG. 8 illustrates a structure in which dual slot regions SR1 and SR2 are formed on the metal plate 1300m of the bottom cover.

Referring to (b) of FIG. 8, the first slot region SR1 and the second slot region SR2 may be formed to have a first length L1 and a second length L2 in one axial direction. In this regard, the first length L1 and second length L2 of the first slot region SR1 and the second slot region SR2 may change in various ways depending on the application.

The metal plate 1300m may include a first metal plate 1310 to a third metal plate 1330. The first metal plate 1310 may be configured to be connected to the third metal pattern 1113 of the radiator 1110. The first metal plate 1310 may be formed in an area (region) above the first slot region SR1 in another axial direction.

The second metal plate 1320 may be disposed between the upper end of the first slot region SR1 in the another axial direction and the lower end of the second slot region SR2 in the another axial direction. The third metal plate 1330 may be formed in an area below the lower end of the second slot region SR2 in the another axial direction.

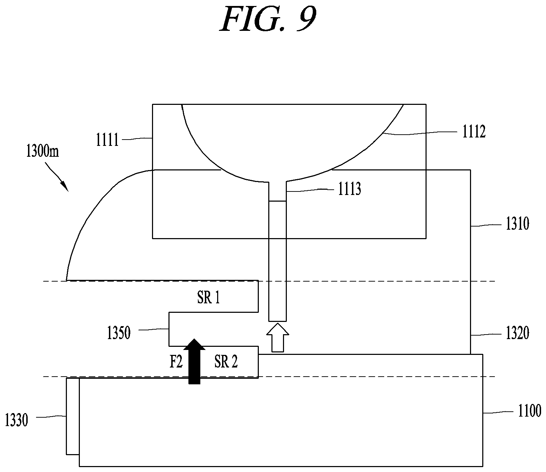

Meanwhile, the antenna module including the wideband radiator described herein may optimize antenna performance by disposing the radiator on the upper region of the metal plate with the dual slot region structure. In this regard, FIG. 9 is a front view of an antenna module in which a radiator is disposed on the upper region of a metal plate having a dual slot region structure according to the present disclosure.

Referring to FIG. 9, the PCB 1100 may be disposed on the top of the front surface of the metal plate 1300m of the bottom cover. The PCB 1100 may be disposed so as not to overlap the first and second slot regions SR1 and SR2 formed on the bottom cover 1300.

Meanwhile, the first feeder F1 may be configured to apply the first signal of the first band to the radiator 1100 through the third metal pattern 1113 of the radiator 1100. On the other hand, the second feeder F2 may be configured to apply the first signal of the second band higher than the first band through the second slot region SR2. Accordingly, the antenna module may be configured to operate as a wideband antenna in the vehicle in the full LB band for 4G and 5G communication.

Meanwhile, the dual slot structure for the wideband antenna according to the present disclosure may be configured to form different current distributions in different frequency bands. Accordingly, the dual slot structure for the wideband antenna according to the present disclosure may operate as a radiator in both 4G/5G LB band and a WiFi band.

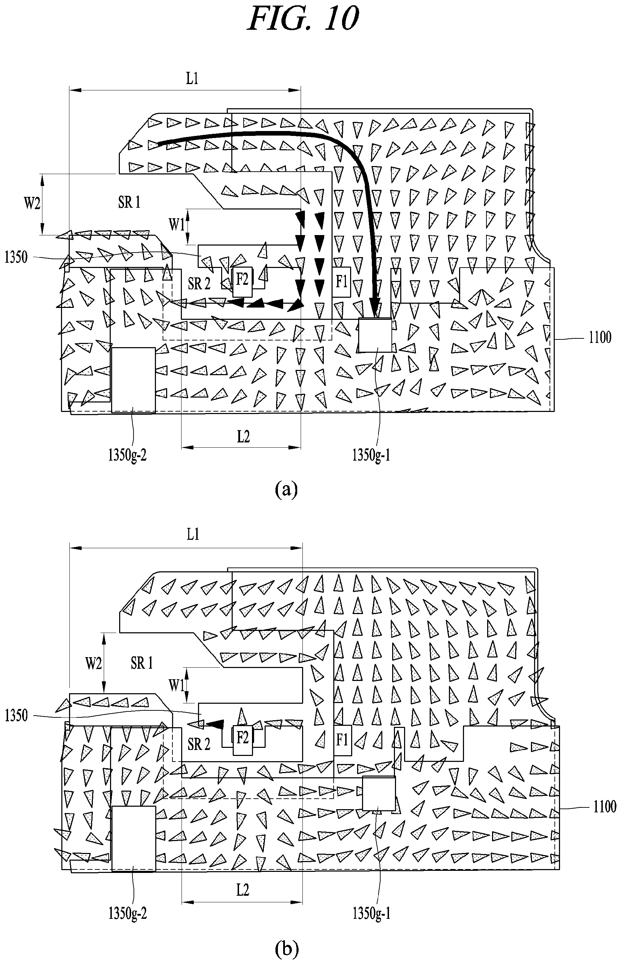

In this regard, FIG. 10 illustrates a current distribution formed on the metal plate of a bottom cover according to the present disclosure. (a) of FIG. 10 illustrates the current distribution when the first signal of the second band is applied through the second feeder F2. On the other hand, (b) of FIG. 10 illustrates the current distribution when the second signal of the third band is applied through the third feeder F3.

Referring to (a) of FIG. 10, the antenna may be configured to radiate the first signal of the second band through slot regions including the first slot region SR1 and the second slot region SR2, thus to operate in a first slot mode. In this regard, since the current path in the first slot mode is formed through the entire slot regions SR1 and SR2, the metal plate 1300m may operate as an antenna in the LB band such as about 920 MHz.

Referring to (b) of FIG. 10, the antenna may be configured to radiate the second signal of the third band through the second slot region SR2, thus to operate in a second slot mode. In this regard, since the current path in the second slot mode is formed through the second slot region SR2, the metal plate 1300m may operate as an antenna in a WiFi band such as about 2.4 GHz.

Meanwhile, the wideband antenna with the dual slot structure disclosed herein may be referred to as a multi-stage slot structure because at least one of the plurality of slot regions forms a step. Meanwhile, the length of the branch member 1350 between the first slot region SR1 and the second slot region SR2 may be optimized for antenna performance. In this regard, the first slot region SR1 may be formed to have a first width W1 in a first region. The first slot region SR1 may be formed to have a second width W2 that is wider than the first width W1 in a second region, which is a side region rather than the first region R1.

The second length L2 of the second slot region SR2 may be shorter than the first length L1 of the first slot region SR1. Accordingly, the end of the second slot region SR2 may be formed in a region more inside than the end of the first slot region SR1. The length of the branch member 1350 may be shorter than the second length L2 of the second slot region SR2. Accordingly, the second slot region SR2 may be formed as a multi-stage slot structure, similar to the first slot region SR1.

As illustrated in (a) and (b) of FIG. 10, the position of the end of the PCB 1100 in the another axial direction may be lower than the position of the lower end of the second slot region SR2. This can suppress the radiation of wireless signals from the first slot region SR1 and the second slot region SR2 from being blocked by the PCB 1100. The first feeder F1 disposed on the front surface of the PCB 1100 may be located in a region that is more inside than the end of the second slot region SR2 in the one axial direction. Accordingly, wireless signals can be radiated through the entire slot regions from the first feeder F1 up to the ends of the first slot region SR1 and the second slot region SR2.

Referring to FIGS. 5 to 7B and FIG. 10, the second feeder F2 disposed on the rear surface of the PCB 1100 may be disposed in a side region rather than the first feeder F1 in the one axial direction. Additionally, the second feeder F2 may be disposed at one point of the second slot region SR2 in the one axial direction. Accordingly, a current path may be formed from the second feeder F2 to a partial region of the second slot region SR2, such that wireless signals can be radiated.

Meanwhile, the antenna module 1000 may further include a first ground contact portion 1350g-1 and a second ground contact portion 1350g-2 configured to connect the PCB 1100 and the metal plate 1300m of the bottom cover 1300. The first ground contact portion 1350g-1 may be disposed in a region more inside than the first feeder F1 in the one axial direction. The second ground contact portion 1350g-2 may be disposed in a side region rather than the second feeder F2 in the one axial direction. Accordingly, the current path of the first signal of the second band and the second signal of the third band may be formed between the first ground contact portion 1350g-1 and the second ground contact portion 1350g-2.

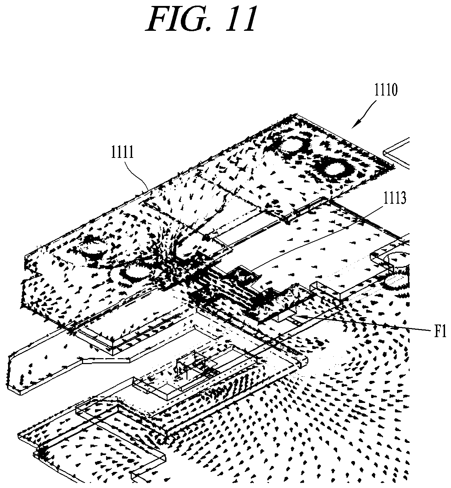

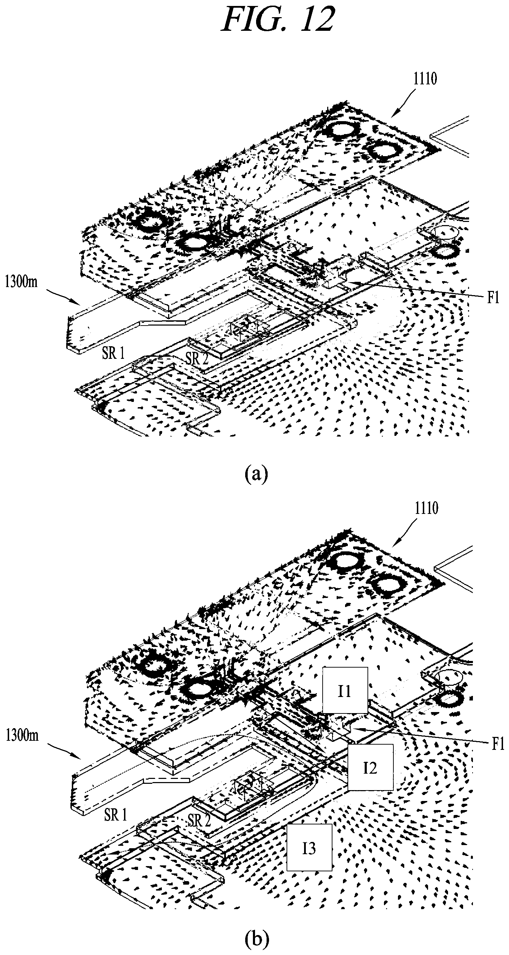

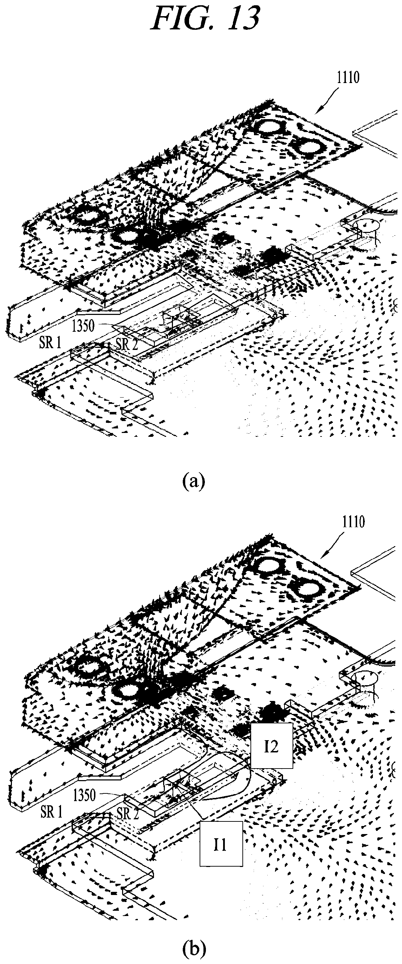

Meanwhile, the wideband antenna structure according to the present disclosure generates different current distributions for each frequency band. In this regard, FIG. 11 illustrates the current distribution in a first band for the wideband antenna structure of FIG. 10. FIG. 12 illustrates a current distribution in a second band and a mechanism thereof with respect to the wideband antenna structure of FIG. 10. FIG. 13 illustrates a current distribution in a third band and a mechanism thereof with respect to the wideband antenna structure of FIG. 10.

Referring to FIGS. 5 and 11, the main antenna for 4G/5G communication in the LB band is configured to radiate the first signal of the first band through the radiator 1110. In particular, the main antenna radiates the first signal of the first band through the first metal pattern 1111 of the radiator 1110. In this regard, the first signal of the first band is applied to the radiator 1110 in a direct feeding manner in which the third metal pattern 1113 is directly connected to the first feeder F1. In relation to this, the current distribution in a region in contact with the third metal pattern 1113 on the metal plate 1300m of the bottom cover is formed to be higher than the current distribution in the other slot regions SR1 and SR2. Accordingly, since the first signal of the first band is radiated through the radiator 1110 in the direct feeding manner and the metal pattern operates as a radiator, it may be referred to as a pattern mode.

Referring to FIG. 5 and (a) of FIG. 12, the main antenna for 4G/5G communication in the LB band is configured to radiate the first signal of the second band through the first slot region SR1 and the second slot region SR2. In particular, the main antenna radiates the first signal of the second band through the first slot region SR1 and the second slot region SR2 on the metal plate 1300m. In this regard, the first signal of the second band is applied to the first slot region SR1 and the second slot region SR2 in the direct feeding manner in which the third metal pattern 1113 is directly connected to the first feeder F1.

Referring to FIG. 5 and (b) of FIG. 12, a first current I1 may be applied to the third metal pattern 1113 disposed on the upper surface of the metal plate 1300m of the bottom cover through the first feeder F1. According to the first current I1 applied to the third metal pattern 1113, a second current 12, which is a current in the opposite direction of the first current, may be formed on the lower surface of the metal plate 1300m of the bottom cover. A third current I3 may be formed along the peripheral region of the slot regions SR1 and SR2 according to the second current I2 formed on the lower surface of the metal plate 1300m of the bottom cover. Accordingly, since the first signal of the second band is radiated through the slot regions SR1 and SR2 in the direct feeding manner and the entire slot regions SR1 and SR2 operate as a radiator, it may be referred to as a large slot mode.

Referring to FIG. 5 and (a) of FIG. 13, the main antenna for WiFi communication is configured to radiate the second signal of the third band through the second slot region SR2. In particular, the WiFi antenna radiates the second signal of the third band through the second slot region SR2 of the metal plate 1300m. In this regard, the third signal of the third band is applied to the second slot region SR2 in a coupling feeding manner with the second feeder F2 extending from the PCB 1100.

Referring to FIG. 5 and (a) of FIG. 13, the first current I1 may be applied to the branch line 1350 through the second feeder F2. A second current I2 may be formed along the peripheral region of the second slot region SR2 according to the first current I1 applied to the branch line 1350. The second current I2 may be formed along a partial region of the first slot region SR1 and the second slot region SR2. Accordingly, since the second signal of the third band is radiated through the partial region of the slot regions SR1 and SR2 in the coupling feeding manner and the partial region of the slot regions SR1 and SR2 operates as a radiator, it may be referred to as a small slot mode.

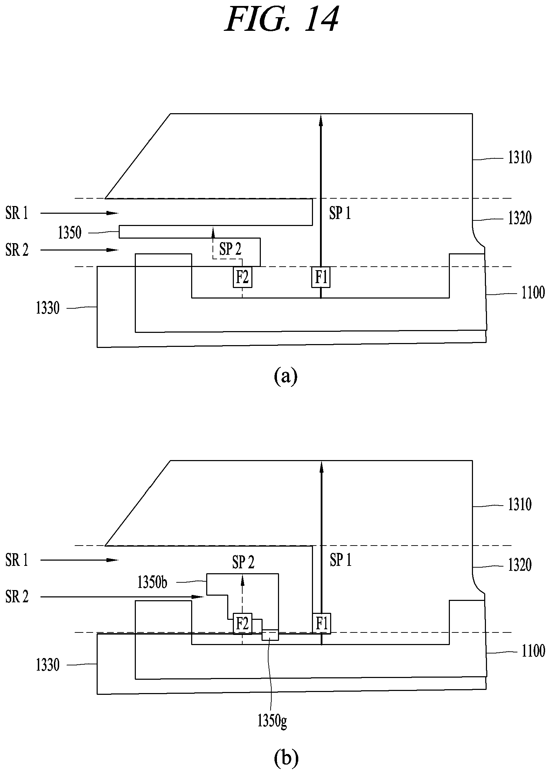

Meanwhile, the wideband antenna structure according to the present disclosure may be configured as a multi-stage slot structure, and the lengths of the slot region and branch line may vary depending on the application. In this regard, FIG. 14 illustrates branch line structures according to different examples of the present disclosure. Referring to (a) of FIG. 14, the position of the end of the branch line 1350 may be disposed more inside than the positions of the ends of the first metal plate 1310 and the third metal plate 1330. A first signal path SP1 may be formed by the first signals of the first band and the second band through the first feeder F1. A second current path SP2 on the second slot region SR2 may be formed by the second signal of the third band through the second feeder F2.

Referring to (b) of FIG. 14, the branch line 1350b may be configured as a separate board, that is, a separate PCB without being connected to the second metal plate 1320. The branch line 1350b may be connected to the third metal plate 1330 through the ground contact portion 1350g. The position of the end of the branch line 1350 may be disposed more inside than the positions of the ends of the first metal plate 1310 and the third metal plate 1330, similar to (a) of FIG. 14. A first signal path SP1 may be formed by the first signals of the first band and the second band through the first feeder F1. A second current path SP2 on the second slot region SR2 may be formed by the second signal of the third band through the second feeder F2. The second slot region SR2 is a slot region disposed in the lower region of the branch line 1350b corresponding to the metal pattern in the WiFi band.

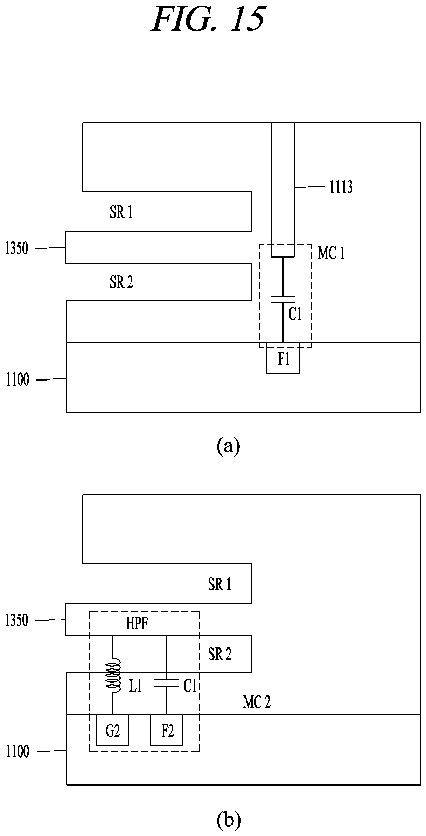

Meanwhile, the feeder of the wideband antenna structure according to the present disclosure may optimize impedance matching characteristics through a matching circuit. In this regard, FIG. 15 illustrates a matching circuit of a wideband antenna structure according to the present disclosure. Referring to FIGS. 5, 14, and 15, the antenna module 1000 may further include a first matching circuit MC1 and a second matching circuit MC2.

Referring to FIGS. 5 and 14 and (a) of FIG. 15, the first matching circuit MC1 may be configured to be connected between the first feeder F1 and the PCB 1100. The second matching circuit MC2 may be connected between the second feeder F2 and the PCB 1100. The first matching circuit MC1 may include a first capacitor C1 with a serial configuration to match impedance between the radiator 1110 and the first feeder F1 for the first signal of the first band. In addition, the first matching circuit MC1 may include a first capacitor C1 with a serial configuration to match impedance between the slot region SR1, SR2 and the first feeder F1 for the first signal of the second band. Therefore, for 4G/5G communication in the first band and the second band, the capacitor C1 may be disposed between the first feeder F1 and the third metal pattern 1113. For example, the capacitance value of the capacitor C1 may be 3 pF, but is not limited thereto, and may vary depending on the application.

Referring to FIGS. 5 and 14, and (b) of FIG. 15, the second matching circuit MC2 may include a high pass filter HPF to match impedance between the second slot region SR2 and the second feeder F2 for the second signal of the third band. For this purpose, the high pass filter HPF may include a second capacitor C2 and an inductor L1 with serial and parallel configurations.

For example, the capacitance value of the second capacitor C2 may be 2 pF, but is not limited thereto, and may vary depending on the application. As another example, the capacitance value of the second capacitor C2 may be reduced to 0.5 pF to improve the isolation between the first and second feeders. Meanwhile, the inductance value of the inductor L1 having the parallel configuration may be set to 3 nH to improve the isolation to less than -12 dB. By optimizing the HPF configuration and the inductance value by the inductor L1 having the parallel configuration, the isolations between LB and WiFi and between MB and WiFi can be improved. As another example, the Wi-Fi resonance frequency may be adjusted by increasing the inductance value of the inductor L1 having the parallel configuration up to 10 nH. Accordingly, the capacitance value of the second capacitor C2 may be selected in a range from about 0.5 pF to about 2 pF. Additionally, in order to adjust the resonance frequency and improve the isolation, the inductance value of the inductor L1 having the parallel configuration may be selected in the range from about 3 nH to about 10 nH.

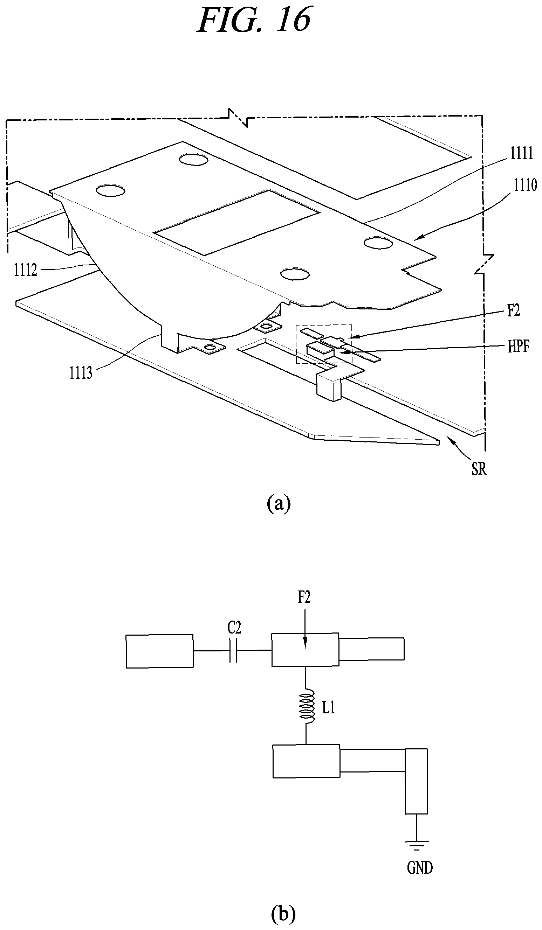

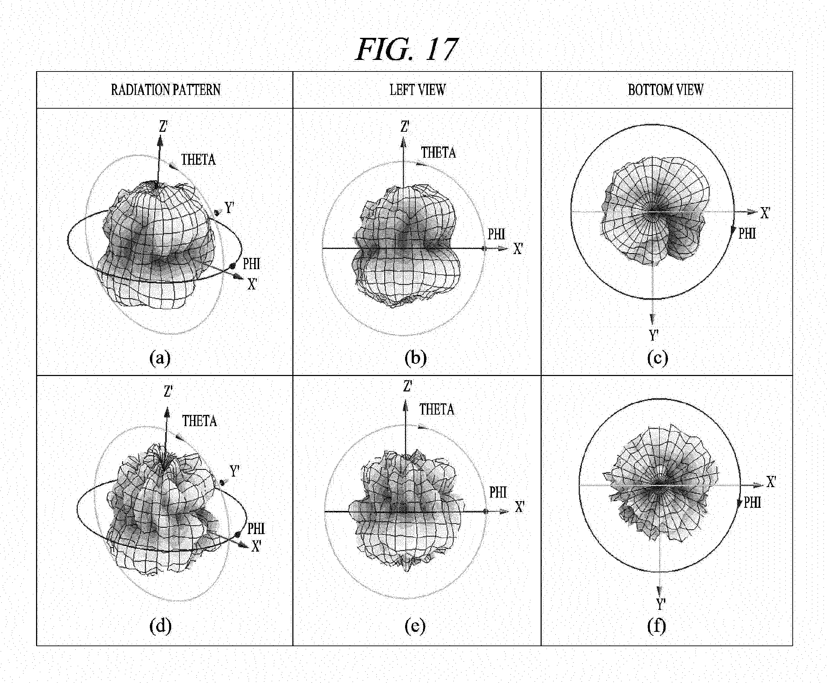

Through this matching circuit configuration, an antenna operating in the Wi-Fi band can be configured to operate in a 5.4GHz band in addition to a 2.4GHz band. In this regard, FIG. 16 illustrates the configuration of a matching circuit disposed between the second feeder and the slot region. On the other hand, FIG. 17 illustrates 3D radiation patterns in the 2.4 GHz band and the 5.4 GHz band and left view and bottom view thereof.

Referring to (a) of FIG. 16, a WiFi antenna may be implemented through the slot region SR, separately from the radiator 1110 having the first metal pattern 1111 to the third metal pattern 1113. The WiFi antenna is not limited to the structure with the single slot region SR as illustrated in (a) of FIG. 16, and the structure with the dual slot regions SR1 and SR2 of FIGS. 9 to 15 may be applied. Referring to (b) of FIG. 15 and (a) of FIG. 16, the high pass filter HPF may be disposed between the second feeder F2 and the slot region SR.

Referring to (b) of FIG. 15 and (b) of FIG. 16, the second matching circuit MC2 may include a high pass filter HPF to match impedance between the second slot region SR2 and the second feeder F2 for the second signal of the third band. To this end, the high pass filter HPF may include a second capacitor C2 connected in series, and an inductor L1 connected in parallel to the second capacitor C2 and connected to a ground GND.

Referring to FIGS. 16 and 17, a WiFi antenna operating in the WiFi band may have a radiation pattern to enable bottom radiation. (a) to (c) of FIG. 17 show a 3D radiation pattern in the 2.4 GHz band and its left view and bottom view. (d) to (f) of FIG. 17 show a 3D radiation pattern in the 5.4GHz band and its left view and bottom view.

Referring to (a) to (f) of FIG. 17, similar radiation patterns are formed in the 2.4 GHz band and the 5.4 GHz band. Specifically, the WiFi antenna may form radiation patterns so that top radiation and bottom radiation occur in the 2.4 GHz band and the 5.4 GHz band.

Referring to the left views of the radiation patterns in (b) and (d) of FIG. 17, the radiation pattern is formed on the x-z plane in a symmetrical structure on the upper and lower regions. The radiation pattern on the horizontal plane (z=0) may have a value lower than the radiation patterns at the top and bottom. Accordingly, WiFi communication can be implemented through the WiFi antenna for a vehicle in inner and outer regions of the vehicle. The outer region of the vehicle may correspond to the upper region of the radiation pattern and the inner region of the vehicle may correspond to the lower region of the radiation pattern.

Referring to the bottom views of the radiation patterns in (c) and (f) of FIG. 17, the radiation patterns are formed in all directions on the x-y plane. Accordingly, WiFi communication can be implemented through the WiFi antenna for a vehicle in inner and outer regions of the vehicle. This can allow reception and transmission of WiFi wireless signals in all directions in the inner region of the vehicle. Accordingly, the WiFi antenna can be configured to operate in the 2.4 GHz band and the 5.4 GHz band not only in the outer region of the vehicle but also in the inner region of the vehicle.

Referring to FIGS. 16 and 17, the slot region SR of the metal plate 1300 of the bottom cover is used as a radiator for the WiFi antenna. Meanwhile, in order to minimize interference with the 4G/5G radiator 1100, the high pass filter HPF may be applied to the second feeder F2 of the WiFi antenna. To this end, the matching circuit MC2 may include a second capacitor C2 disposed between a feeding pad for the second feeder F2 and a separate PCB pad. Meanwhile, the matching circuit MC2 may be configured as a high pass filter HPF by further including an inductor L1 disposed between the feeding pad for the second feeder F2 and the ground GND. The matching circuit MC2 may include only the second capacitor C2 connected in series without an inductor configuration depending on the application.

The wideband antenna structures disclosed therein may be disposed at different locations within the antenna module to be spaced apart from each other. To correspond to the antenna elements disposed at different positions to be spaced apart from each other, slot regions may be formed at different positions of the metal plate 1300m of the bottom cover 1300. Meanwhile, mold covers may be disposed to correspond to the positions where the slot regions are formed.

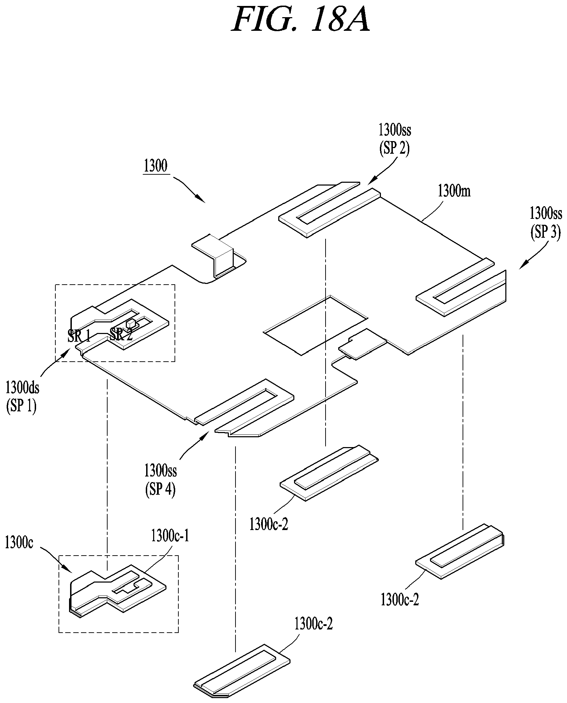

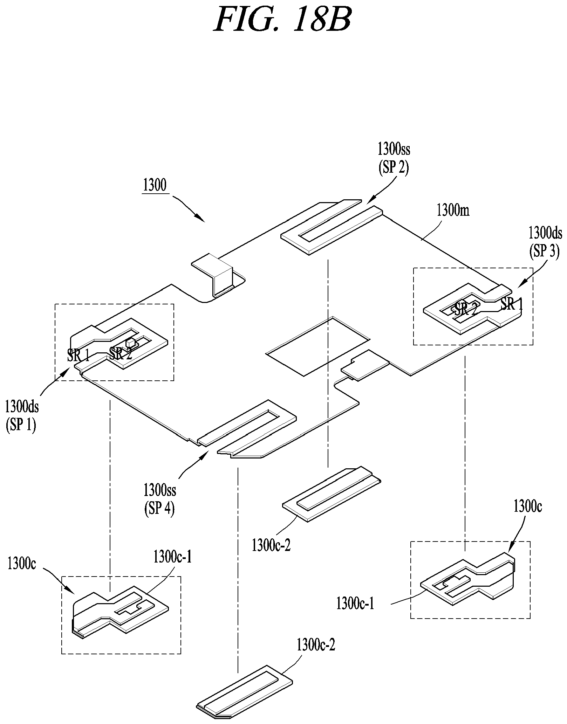

In this regard, FIGS. 18A and 18B illustrate slot regions formed at different positions on the metal plate of a lower cover according to embodiments. Referring to FIGS. 5 to 18B, the main antenna may include a first antenna, a second antenna, a third antenna, and a fourth antenna that are disposed on top and bottom of one side and on top and bottom of another side of the metal plate 1300m of the bottom cover. Mold covers 1300c made of a dielectric material may be disposed on a first slot portion SP1 to a fourth slot portion SP4 corresponding to the first to fourth antennas.

Specifically, FIG. 18A illustrates a structure in which a dual slot region 1300ds is disposed at the first position on the metal plate 1300m of the bottom cover 1300. The first slot region SR1 and the second slot region SR2, as described above, may be formed in the dual slot region 1300ds. On the other hand, single slot regions 1300ss may be disposed at the remaining second to fourth positions on the metal plate 1300m of the bottom cover 1300. Only one slot is disposed in each single slot region 1300ss.

A first type mold cover 1300c-1 coupled to the dual slot region 1300ds may be disposed in the dual slot region 1300ds. On the other hand, a second type mold cover 1300c-2 coupled to the single slot region 1300ss may be disposed in the single slot region 1300ss. When the dual slot region 1300ds is formed, the antenna element may operate up to the second band of the LB band. On the other hand, when the single slot region 1300ss is formed, the antenna element may operate only in the first band of the LB band even if the radiator is disposed.

FIG. 18B illustrates a structure in which the dual slot regions 1300ds are disposed at the first position and the third position on the metal plate 1300m of the bottom cover 1300. The locations where the dual slot regions 1300ds are disposed are not limited to this and may vary depending on the application. The first slot region SR1 and the second slot region SR2, as described above, may be formed in each of the dual slot regions 1300ds. On the other hand, single slot regions 1300ss may be disposed at the remaining second and fourth positions on the metal plate 1300m of the bottom cover 1300. Only one slot is disposed in each single slot region 1300ss.

A first type mold cover 1300c-1 coupled to the dual slot region 1300ds may be disposed in the dual slot region 1300ds. On the other hand, a second type mold cover 1300c-2 coupled to the single slot region 1300ss may be disposed in the single slot region 1300ss. When the dual slot region 1300ds is formed, the antenna element may operate up to the second band of the LB band. On the other hand, when the single slot region 1300ss is formed, the antenna element may operate only in the first band of the LB band even if the radiator is disposed.

Accordingly, at the first and third positions where the dual slot regions 1300ds are disposed, MIMO may be performed in the second band through the first feeder F1 and the slot regions SR1 and SR2 of FIGS. 5 and 6. On the other hand, at the first to fourth positions where the single slot region 1300ss or the dual slot region 1300ds is disposed, MIMO may be performed in the first band through the first feeder F1 and the radiator 1110 of FIGS. 5 and 6.

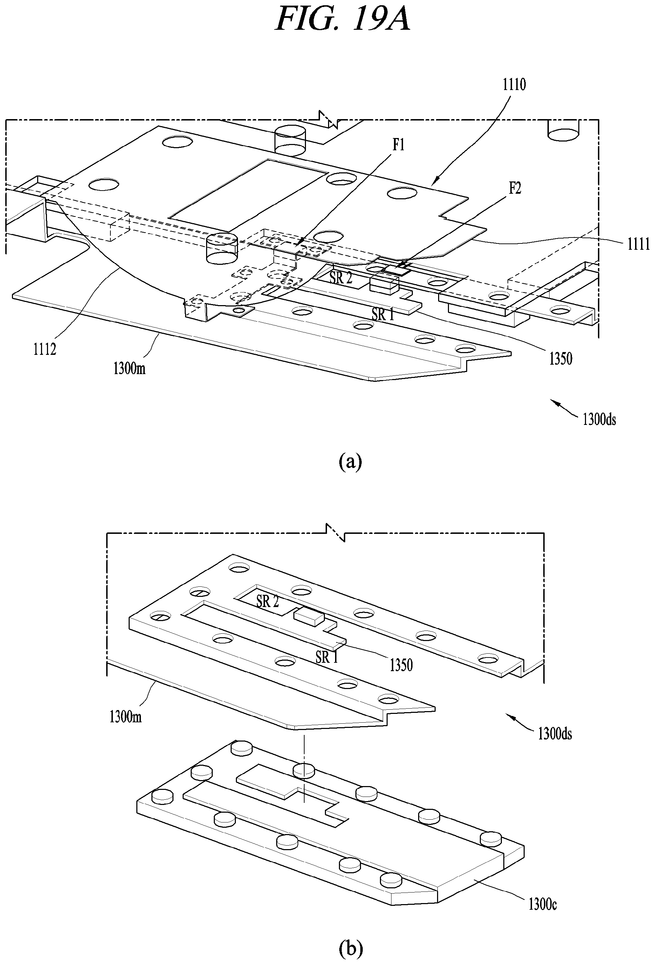

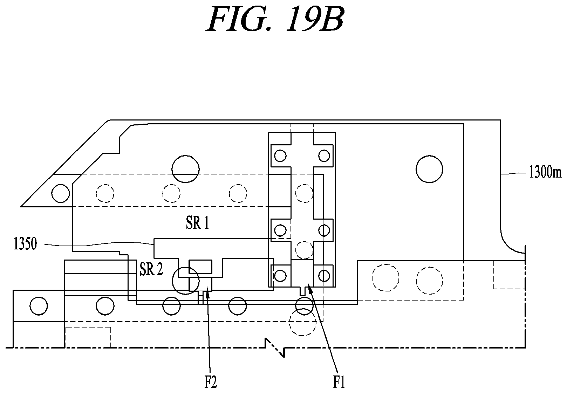

Meanwhile, the wideband antenna structure with the dual slot region according to the present disclosure may be configured so that the metal plate of the bottom cover and the mold cover are coupled to each other. In this regard, FIG. 19A illustrates a region where a dual slot region is formed at one point of an antenna module according to the present disclosure, and a structure in which a mold cover can be coupled to the region. On the other hand, FIG. 19B is a front view of (a) of FIG. 19A, which is a state before the mold cover is coupled.

Referring to (a) of FIG. 19A and FIG. 19B, the third metal pattern 1113 of the radiator 1110 may be connected through the first feeder F1. Referring to FIG. 15, (a) of FIG. 17, and FIG. 18, the first matching circuit MC1 may be connected between the third metal pattern 1113 and the first feeder F1. Meanwhile, the branch member 1350 forming the second slot region SR2 may be connected through the second feeder F2. The second matching circuit MC2 may be connected between the branch member 1350 and the second feeder F2.

Referring to (b) of FIG. 19A, the mold cover 1350 may be coupled with the slot regions SR1 and SR2 of the metal plate 1300m. The mold cover 1350 may be formed as a dual injection structure or as a heat fusion structure. The mold cover 1350 formed with the heat fusion structure may be referred to as a mold fusion structure. Antenna performance may partially change due to the dielectric constant of the mold cover 1350. In particular, the antenna performance may partially change due to the mold cover 1350 in the WiFi band in which the antenna operates in the small slot mode. However, the resonance frequency may be adjusted by partially changing the structure of the second matching circuit MC2 or the slot structure.

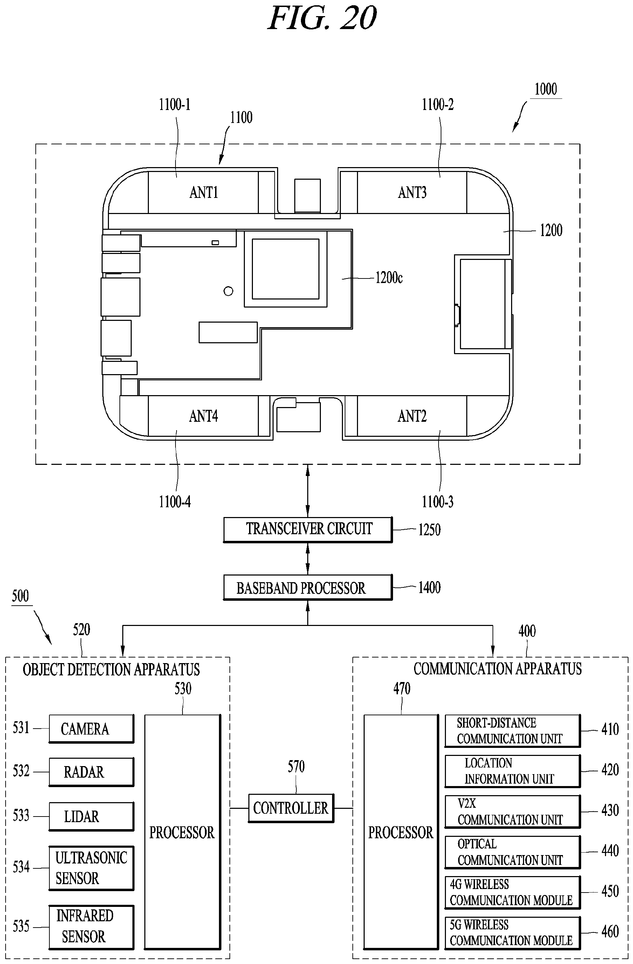

Meanwhile, FIG. 20 shows a configuration diagram of an antenna system according to an embodiment and a vehicle on which the antenna system is mounted. Specifically, FIG. 20 shows a configuration diagram of a vehicle in which an antenna module corresponding to an antenna system is disposed inside a vehicle roof to perform communication with nearby electronic devices, vehicles, and infrastructures.

Referring to FIG. 20, the wideband antenna module 1000 may be mounted on the vehicle. The antenna module 1000 may perform short-range communication, wireless communication, V2X communication, and the like by itself or through the communication apparatus 400. To this end, the baseband processor 1400 may perform control such that a signal is received from or transmitted to the adjacent vehicle, the RSU, and the base station through the antenna module 1000.

Alternatively, the baseband processor 1400 may perform control such that a signal is received from or transmitted to the adjacent vehicle, the RSU, the adjacent object, and the base station through the communication apparatus 400. Here, the information related to adjacent objects may be acquired through the object detecting apparatus such as the camera 531, the radar 532, the LiDar 533, and the sensors 534 and 535 of the vehicle 300. Alternatively, the baseband processor 1400 may control the communication device 400 and the antenna module 1000 such that a signal is received from or transmitted to the adjacent vehicle, the RSU, the adjacent object, and the base station.

Meanwhile, referring to FIGS. 1A to 20, the vehicle 500 having the antenna module 1000 may include the plurality of antennas 1100, the transceiver circuit 1250, and the baseband processor 1400. The vehicle 500 may further include the object detecting apparatus 520. The vehicle 500 may further include the communication apparatus 400. Here, the communication apparatus 400 may be configured to perform wireless communication through the antenna unit.

Referring to FIGS. 1A to 20, the vehicle 500 may include the antenna module 1000. The antenna module 1000 may be disposed on the bottom of the roof of the vehicle, and perform communication with at least one of an adjacent vehicle, a Road Side Unit (RSU), and a base station through the processor. Since the antenna module 1000 performs telematics operations through wireless communication in the vehicle, it may also be referred to as a telematics module. In this regard, the second PCB 1200 in the antenna module 1000 may be coupled with the telematics module 1200c that performs a telematics function. In this regard, the second PCB 1200 and the telematics module 1200c may be combined to interface with each other on the same plane.

Referring to 1A to 20, the vehicle 500 provided with the antenna module 1000 according to another aspect of this specification will be described. The vehicle 500 includes the antenna module 1000 disposed below the roof of the vehicle. The vehicle 500 may further include the processor 1400 disposed inside or outside the antenna module 1000 and configured to communicate with at least one of an adjacent vehicle, a road side unit (RSU), and a base station.

The antenna module 1000 mounted on the vehicle may include a PCB 1110, a radiator 1110, a bottom cover 1300, and a top cover 1300u. Electronic components may be disposed on the PCB 1100. A PCB on which an antenna element such as the radiator 1110 may be disposed may be referred to as an antenna PCB 1100. Meanwhile, the antenna PCB 1100 may be configured to be coupled to the second PCB 1200 on which other electronic components are disposed. In this regard, the PCB 1100 and the second PCB 1200 may be formed as an integral PCB or separate PCBs.

The radiator 1110 may be configured to be electrically connected to the PCB 1100 through a side region. The radiator 1110 may be formed as a metal pattern with predetermined length and width and configured to transmit and receive a first signal of a first band. In this regard, the first signal may be an LB signal for 4G communication or 5G communication. The first band may be a first sub-band of the LB band and may be about 700 MHz, but is not limited thereto.

The bottom cover 1300 may be disposed below the PCB 1100 and may be configured as a metal plate having slots regions SR1 and SR2. The top cover 1300u may be fastened to the bottom cover 1300 to accommodate the PCB 1100 and the radiator 1110 therein.

The metal plate 1300m of the bottom cover 1300 may include a first slot region SR1, a second slot region SR2, and a branch member 1350. The first slot region SR1 may be formed to have predetermined length and width on one side of the metal plate 1300m. The second slot region SR2 may be formed to have predetermined length and width to be parallel to the first slot region SR1. The branch member 1350 may be a metal plate having predetermined length and width between the first slot region SR1 and the second slot region SR2.

The antenna module may be configured to include a first feeder F1. The first feeder F1 may be disposed on the front surface of the PCB 1100. The first feeder F1 may be connected to the radiator 1110 to feed the first signal of the first band to the radiator. Additionally, the first feeder F1 may be connected to the radiator 1110 to feed the first signal of the second band to the slot regions SR1 and SR2. Additionally, the PCB 1100 may be connected to the bottom cover 1300 through a ground contact portion GC.

As described above, the first signal may be an LB signal for 4G communication or 5G communication. The second band may be a second sub-band of the LB band that is higher than the first sub-band and may be about 920 MHz, but is not limited thereto.

The radiator 1100 configured to radiate the first signal of the first band and the slot regions SR1 and SR2 of the metal plate 1300m configured to radiate the first signal of the second band may constitute a main antenna. The main antenna may be configured to operate in the LB band of the 4G communication or 5G communication bands.

The antenna module may further include a second feeder F2. The second feeder F2 may be configured to be disposed between the branch line 1350 and the metal plate forming the second slot region SR2. The second feeder F2 may be configured to feed a second signal of a third band higher than the second band to the second slot region SR2. The third band may be a frequency band for WiFi communication, and the second signal may be a WiFi signal. Accordingly, the second slot region SR2 configured to radiate the second signal of the third band may configure a WiFi antenna operating in the WiFi frequency band.

Meanwhile, a first antenna (ANT1) 1100-1, a second antenna (ANT2) 1100-2, a third antenna (ANT2) 1100-3, and a fourth antenna (ANT4) 1100-4 that are disposed on top and bottom of one side and top and bottom of another side of the bottom cover 1300. First to fourth slot portions SP1 to SP4 may be disposed to correspond to the first to fourth antennas (ANT1 to ANT4) 1100-1 to 1100-4.

Some of the first to fourth slot portions SP1 to SP4 may configure a dual slot region 1350ds including a first slot region SR1, a second slot region SR2, and a branch line 1350. Therefore, MIMO can be carried out through some of the first antenna (ANT1) 1100-1 to the fourth antenna (ANT4) 1100-4 which have the dual slot region 1350ds. In other words, MIMO may be carried out in the second band of the LB band through the first feeder F1 with respect to those antennas having the dual slot region 1350ds. On the other hand, MIMO may be carried out in the first band of the LB band through the first feeder F1 with respect to the first antenna (ANT1) 1100-1 to the fourth antenna (ANT4) 1100-4).

The processor 1400 may control the transceiver circuit 1250 to perform MIMO in the LB band by using two or more antennas having the dual slot region 1350ds among the first antenna (ANT1) 1100-1 to the fourth antenna (ANT4) 1100-4. Specifically, the processor 1400 may control the transceiver circuit 1250 to perform MIMO in the second band of the LB band by using two or more antennas having the dual slot region 1350ds. Also, the processor 1400 may control the transceiver circuit 1250 to perform MIMO in the first band of the LB band by using the first to third antennas (ANT1 to ANT4) 1100-1 to 1100-4.

The transceiver circuit 1250 may be operably coupled to each radiator module 1100. The processor 1400 may be operably coupled to the transceiver circuit 1250. The processor 1400 may be a baseband processor corresponding to a modem, but is not limited thereto and may be any processor that controls the transceiver circuit 1250. The processor 1400 of the vehicle may be implemented as a network access device (NAD).

The transceiver circuit 1250 may be operably coupled to the MIMO antennas ANT1 to ANT4. The transceiver circuit 1250 may include a front end module (FEM) such as a power amplifier or a receiving amplifier. As another example, the front end module (FEM) may be disposed between the transceiver circuit 1250 and the antenna, separately from the transceiver circuit 1250. The transceiver circuit 1250 may control the amplitude and/or phase of signals transmitted to the MIMO antennas ANT1 to ANT4 or control only some antenna modules to operate by adjusting the gain or input or output power of the power amplifier or the receiving amplifier.

The processor 1400 may be operably coupled to the transceiver circuit 1250 and may be configured to control the transceiver circuit 1250. The processor 1400 may control the transceiver circuit 1250 to control the amplitude and/or phase of the signals transmitted to the MIMO antennas ANT1 to ANT4 or to operate only some antenna modules. The processor 1400 may perform communication with at least one of the adjacent vehicle, the road side unit (RSU), and the base station through the transceiver circuit 1250.

In a case where there is a need to simultaneously receive information from various entities such as the adjacent vehicle, the RSU, and the base station for autonomous driving, etc., information may be received and transmitted through MIMO. Therefore, the vehicle may receive different information from various entities at the same time to improve its communication capacity. Therefore, the communication capacity of the vehicle can be improved through the MIMO without increasing a bandwidth.

Alternatively, the vehicle may simultaneously receive the same information from various entities, so as to improve reliability of surrounding information and decrease latency. Accordingly, Ultra Reliable Low Latency Communication (URLLC) can be performed in the vehicle and the vehicle can operate as a URLLC UE. To this end, a base station that performs scheduling may preferentially allocate a time slot for the vehicle operating as the URLLC UE. For this, some of specific time-frequency resources already allocated to other UEs may be punctured.

As described above, the plurality of antennas ANT1 to ANT4 for 4G/5G communication within the antenna module 1000 may operate in the full band including the low band (LB), the mid band (MB), and the high band (HB). Here, the low band (LB) may be referred to as the first (frequency) band and the mid band (MB) and the high band (HB) may be referred to as the second (frequency) band. As another example, when the antenna system 1000 operates in the mid band (MB) and the high band (HB), the middle band (MB) is referred to as a first (frequency) band and the high band (HB) is referred to as a second (frequency) band. The 5G SUB6 band may be the same band as the LTE band in case of LTE re-farming. When 5G NR operates in a band separate from LTE, it may operate in the high band (HB) or a higher band. The 5G SUB6 band operating in the high band (HB) or higher band may also be referred to as a second (frequency) band.

The baseband processor 1400 can perform MIMO through some of the plurality of antenna elements ANT1 to ANT4 in the first frequency band. Also, the baseband processor 1400 can perform MIMO through some of the plurality of antenna elements ANT1 to ANT4 in the second frequency band. In this regard, the baseband processor 1400 can perform MIMO by using antenna elements that are sufficiently spaced apart from each other and disposed by being rotated at a predetermined angle. This can improve isolation between the first and second signals within the same band.

The baseband processor 1400 may control the transceiver circuit 1250 to receive the second signal of the second frequency band while receiving the first signal of the first frequency band through one of the first to fourth antennas ANT1 to ANT4. In this case, there may be provided an advantage that the baseband processor 1400 can advantageously perform carrier aggregation (CA) through one antenna.

Alternatively, the baseband processor 1400 may control the transceiver circuit 1250 to receive the first signal of the second band through any one of the second antenna ANT2 and the fourth antenna ANT4 while receiving the first signal of the second band through any one of the first antenna ANT1 and the third antenna ANT3. In this case, there may be provided an advantage that each antenna can be designed to optimally operate in a corresponding band.

Therefore, the baseband processor 1400 can perform carrier aggregation (CA) through a combination of the first frequency band and the second frequency band. When it is necessary to receive a large amount of data for autonomous driving or the like, reception in a broad band can be allowed through the CA.

Accordingly, eMBB (Enhanced Mobile Broad Band) communication can be performed in the vehicle and the vehicle can operate as an eMBB UE. To this end, the base station that performs scheduling may allocate a broadband frequency resource to the vehicle that operates as the eMBB UE. To this end, the CA may be performed on frequency bands that are available, except for frequency resources already allocated to other UEs.

Regard the frequency band, the low band (LB), the mid band (MB), and the high band (HB) may be referred to as the first band, the second band, and the third band, respectively. The antenna system 1000 may operate as a single antenna in the first band, the second band, and the third band corresponding to the low band (LB), the middle band (MB), and the high band (HB). In this regard, the processor 1400 may determine a resource region allocated through a physical downlink control channel (PDCCH). The processor 1400 may control the transceiver circuit 1250 to perform carrier aggregation in two or more of the first to third bands based on the allocated resource region.

The processor 1400 may perform MIMO in an EN-DC state through the first to fourth antennas ANT1 to ANT4. For example, the processor 1400 may perform an EN-DC operation through the first antenna ANT1 and the second antenna ANT2, and MIMO through the third antenna ANT3 and the fourth antenna ANT4.

In this regard, when the EN-DC operation is performed between the 4G/5G communication system and the WiFi communication system using different bands, the processor 1400 may perform the EN-DC operation through a plurality of antennas in one antenna system. Accordingly, an interference level between MIMO streams using the same band can be reduced. On the other hand, when the EN-DC operation is performed between the 4G and 5G communication systems using the same band, the processor 1400 may perform the EN-DC operation through a plurality of antennas in different antenna systems. In this case, in order to reduce the interference level in the low band (LB), the MIMO operation through the plurality of antennas in the same antenna system may be performed in the mid band (MB) or higher.

It will be clearly understood by those skilled in the art that various modifications and alternations for the aforementioned implementations related to the antenna system having the plurality of antennas, the vehicle having the antenna system, and the control operations thereof are made without departing from the idea and scope of the present disclosure. Therefore, it should be understood that such various modifications and alternations for the implementations fall within the scope of the appended claims.

In the above, an antenna module having a wideband antenna mounted on a vehicle and a vehicle including the antenna module have been described. The technical effects of such antenna module having the wideband antenna mounted on the vehicle and the vehicle equipped with the antenna module will be described as follows.

According to the present disclosure, an antenna structure that operates to cover the full band of 4G/5G low band (LB) can be provided by applying a slot structure to a metal plate disposed on the lower region of a radiator.

According to the present disclosure, an antenna structure that operates even in a WiFi band in addition to a 4G/5G LB band by applying a dual slot structure to a metal plate disposed on the lower region of a radiator.

According to the present disclosure, a dual slot structure and a matching circuit can be applied to a metal plate disposed on the lower region of a radiator, thereby maintaining isolation between an antenna for MIMO and a WiFi antenna while optimizing the performances of the antennas.

According to the present disclosure, antennas can be implemented on a PCB in an antenna module and the metal plate of a bottom cover, to provide wireless signals to the inner region of a vehicle even when a vehicle body or roof is made of a metal material.

According to the present disclosure, an antenna with a slot structure can be implemented on the metal plate of a bottom cover of an antenna module, thereby providing an antenna operating in a dual mode while utilizing a ground region of a body constituting the antenna module as an antenna.

According to the present disclosure, an antenna with a slot structure can be implemented on the metal plate of a bottom cover within an antenna module, antenna performance can be improved while maintaining the height of an antenna system below a predetermined level.

According to the present disclosure, a structure for mounting an antenna system capable of operating in a wide band on a vehicle to support various communication systems can be provided.

Further scope of applicability of the present disclosure will become apparent from the following detailed description. It should be understood, however, that the detailed description and specific examples, such as the preferred embodiment of the present disclosure, are given by way of illustration only, since various modifications and alternations within the spirit and scope of the disclosure will be apparent to those skilled in the art.

In relation to the foregoing description, the antenna system mounted in the vehicle and the operation of controlling the same may be implemented by software, firmware, or a combination thereof. Meanwhile, the design of the antenna system mounted on the vehicle and the configuration of controlling the antenna system can be implemented as computer-readable codes in a program-recorded medium. The computer-readable medium may include all types of recording devices each storing data readable by a computer system. Examples of such computer-readable media may include hard disk drive (HDD), solid status disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the invention should be determined by reasonable interpretation of the appended claims and all changes that come within the equivalent scope of the invention are included in the scope of the disclosure.

## Claims

1. An antenna module mounted on a vehicle, the antenna module comprising:
a printed circuit board (PCB) on which electronic components are disposed;
a radiator electrically connected to the PCB, through a side region, and configured as a metal pattern having predetermined length and width to transmit and receive a first signal;
a bottom cover disposed on a bottom of the PCB and configured as a metal plate with slot regions; and
a top cover fastened to the bottom cover and configured to accommodate the PCB and the radiator therein,
wherein the metal plate comprises:
a first slot region formed on one side of the metal plate to have predetermined length and width;
a second slot region formed parallel to the first slot region to have predetermined length and width; and
a branch member disposed between the first slot region and the second slot region and formed of a metal plate having predetermined length and width.

2. The antenna module of claim 1, further comprising a first feeder disposed on a front surface of the PCB, and connected to the radiator to feed a first signal of a first band to the radiator, and
the first signal is a low band (LB) signal for 4G communication or 5G communication.

3. The antenna module of claim 1, wherein the radiator comprises:
a first metal pattern disposed parallel to the top cover and having an opening region;
a second metal pattern connected vertically to the upper metal pattern and forming a side region; and
a third metal pattern connected to the second metal pattern and the first feeder and configured to transmit the first signal of the first band to the second metal pattern.

4. The antenna module of claim 1, wherein the first feeder is configured to feed a first signal of a second band higher than the first band to the slot regions,
the PCB is configured to be connected to the bottom cover through a ground contact portion, and
the first band is a first sub-band of the low band (LB), and the second band is a second sub-band higher than the first sub-band of the low band (LB).

5. The antenna module of claim 4, wherein the radiator configured to radiate the first signal of the first band and the slot regions of the metal plate configured to radiate the first signal of the second band constitute a main antenna that operates in the low band (LB) of 4G communication or 5G communication bands.

6. The antenna module of claim 4, further comprising a second feeder disposed between the branch line and the metal plate forming the second slot region, and configured to feed a second signal of a third band higher than the second band to the second slot region, and
the third band is a frequency band for WiFi communication.

7. The antenna module of claim 6, wherein the second slot region configured to radiate the second signal of the third band constitutes a WiFi antenna operating in a WiFi frequency band.

8. The antenna module of claim 5, wherein the radiator operates as a first radiator that radiates the first signal of the first band fed from the first feeder,
the slot regions operate as a second radiator that radiates the first signal of the second band fed from the second feeder, and
the first radiator and the second radiator constitute the main antenna.

9. The antenna module of claim 5, wherein the main antenna is configured to radiate the first signal of the first band through the radiator, and
is configured to radiate the first signal of the second band through the slot regions including the first slot region and the second slot region, thus to operate in a first slot mode.

10. The antenna module of claim 7, wherein the WiFi antenna is configured to radiate the second signal of the third band through the second slot region, thus to operate in a second slot mode.

11. The antenna module of claim 6, wherein the first slot region and the second slot region are formed to have a first length and a second length in one axial direction, and
the metal plate comprises:
a first metal plate connected to the third metal pattern of the radiator and disposed in a region above the first slot region in another axial direction;
a second metal plate disposed between an upper end of the first slot region in the another axial direction and a lower end of the second slot region in the another axial direction; and
a third metal plate disposed in a region below the lower end of the second slot region in the another axial direction.

12. The antenna module of claim 11, wherein the first slot region is formed to have a first width in a first region, and a second width wider than the first width in a second region that is a side region rather than the first region, and
an end of the second slot region is disposed in a region more inside than an end of the first slot region, and a length of the branch member is shorter than the second length of the second slot region.

13. The antenna module of claim 12, wherein a position of an end of the PCB in the another axial direction is lower than a position of the lower end of the second slot region, and
the first feeder disposed on the front surface of the PCB is located in a region in the one axial direction more inside than the end of the second slot region.

14. The antenna module of claim 12, wherein the second feeder disposed on a rear surface of the PCB is disposed in a side region rather than the first feeder in the one axial direction, and disposed at one point of the second slot region in the one axial direction,
the antenna module further comprises a first ground contact portion and a second ground contact portion configured to connect the PCB and the metal plate of the bottom cover, and
the first ground contact portion is disposed in a region in the one axial direction more inside than the first feeder, and the second ground contact portion is disposed in a side region rather than the second feeder in the one axial direction.

15. The antenna module of claim 6, further comprising:
a first matching circuit connected between the first feeder and the PCB; and
a second matching circuit connected between the second feeder and the PCB,
wherein the first matching circuit comprises a first capacitor with a serial configuration to match impedance between the radiator and the first feeder for the first signal of the first band, and
the second matching circuit comprises a second capacitor and an inductor with serial and parallel configurations to match impedance between the second slot region and the second feeder for the second signal of the third band.

16. The antenna module of claim 6, wherein the main antenna comprises a first antenna, a second antenna, a third antenna, and a fourth antenna that are disposed on top and bottom of one side and on top and bottom of another side of the bottom cover, and
mold covers made of a dielectric material are disposed on a first slot portion to a fourth slot portion corresponding to the first to fourth antennas.

17. A vehicle having an antenna module mounted thereon, the vehicle comprising:
an antenna module disposed below a roof of the vehicle; and
a processor disposed inside or outside the antenna module, and configured to communicate with at least one of an adjacent vehicle, a road side unit (RSU), and a base station,
wherein the antenna modules comprises:
a printed circuit board (PCB) on which electronic components are disposed;
at least one radiator electrically connected to the PCB, and configured as a metal pattern having predetermined length and width to transmit and receive a first signal;
a bottom cover disposed on a bottom of the PCB and configured as a metal plate with slot regions; and
a top cover fastened to the bottom cover and configured to accommodate the PCB and the at least one radiator therein, and
the metal plate comprises:
a first slot region formed on one side of the metal plate to have predetermined length and width;
a second slot region formed parallel to the first slot region to have predetermined length and width; and
a branch member disposed between the first slot region and the second slot region and formed of a metal plate having predetermined length and width.

18. The vehicle of claim 17, further comprising:
a first feeder disposed on a front surface of the PCB, and connected to the radiator to feed a first signal of a first band and a first signal of a second band to the radiator; and
a second feeder disposed between the branch line and the metal plate forming the second slot region, and configured to feed a second signal of a third band higher than the second band to the second slot region, and
the first signal is a low band (LB) signal for 4G communication or 5G communication, the first band is a first sub-band of the low band (LB), the second band is a second sub-band higher than the first sub-band of the low band (LB), and the third band is a frequency band for WiFi communication.

19. The vehicle of claim 17, wherein a first antenna, a second antenna, a third antenna, and a fourth antenna are disposed on top and bottom of one side and on top and bottom of another side of the bottom cover, and a first slot portion to a fourth slot portion are disposed to correspond to the first to fourth antennas, and
some of the first to fourth slot portions are configured to have a dual slot region including the first slot region, the second slot region, and the branch line, and the rest of the first to fourth slot portions is configured to have a single slot region.

20. The vehicle of claim 19, wherein the processor performs multi-input/multi-output (MIMO) in the low band (LB) by using two or more antennas having the dual slot region among the first antenna to the fourth antenna.
